# EUROPEAN PATENT APPLICATION

(11) **EP 4 672 873 A1**
(43) Date of publication of application: **31.12.2025**
(21) Application number: 24770517.1
(22) Date of filing: 27.02.2024
(51) Int. Cl.: H05K 3/40, H01L 21/768, H01L 23/522, H05K 1/11

(54) **METHOD FOR MANUFACTURING ELECTROCONDUCTIVE-VIA-EQUIPPED SUBSTRATE, ELECTROCONDUCTIVE-VIA-EQUIPPED SUBSTRATE, AND METAL PASTE**

(30) Priority: 15.03.2023 JP 2023040854
(71) Applicant: Resonac Corporation, Tokyo 105-7325 (JP)
(72) Inventor: EJIRI Yoshinori, Tokyo 105-7325 (JP); SAKAMOTO Masumi, Tokyo 105-7325 (JP); SHIMIZU Chiaki, Tokyo 105-7325 (JP); SUKATA Shinichirou, Tokyo 105-7325 (JP); NAKAKO Hideo, Tokyo 105-7325 (JP)
(74) Representative: Kraus & Lederer PartGmbB
(86) International application number: PCT/JP2024/007149
(87) International publication number: WO 2024/190405

(57) **Abstract**

A method for manufacturing a conductive via-containing substrate is provided, the method including: step a of preparing a substrate provided with a hole and providing a metal paste part containing metal particles and a volatile solvent to cover at least a surface surrounding the hole of the substrate while an inside of the hole is filled with the metal paste part; step b of heating the metal paste part to remove a part of the volatile solvent; step c of removing a part of the metal paste part after heating to expose the surface to form a conductive via precursor in the hole, the conductive via precursor containing the metal particles and a residue of the volatile solvent and having a planarized exposed surface; and step d of firing the conductive via precursor, in which the metal particles include first copper particles having an average particle diameter of 0.8 µm or more, second copper particles having an average particle diameter of 0.5 µm or less, and solder particles, and the metal particles in the metal paste part provided in step a have a concentration of 94% by mass or more.

## Description

### Technical Field

The present invention relates to a method for manufacturing a conductive via-containing substrate, a conductive via-containing substrate, and a metal paste.

### Background Art

In recent years, in order to reduce the size, increase the functionality, and achieve the integration of electronic devices or components, a three-dimensional mounting technology has attracted attention, in which silicon substrates arranged in a top-and-bottom arrangement are electrically connected to each other via an electrode, which is called a through silicon via (TSV), and semiconductor chips are stacked in a vertical direction (height direction) at a high density.

As a technique for forming a through electrode, for example, it is disclosed in Patent Literature 1 that a method for manufacturing a semiconductor device that has a through silicon via includes a step of performing copper plating on a blind-via formed on a silicon substrate by electroplating using a specific copper plating solution. However, such a method has problems in terms of productivity because it is necessary to perform plating while reducing the deposition rate of a copper film, resulting in a long operation time.

As another technique, it is known as a method for filling a through-hole of a heat-resistant substrate with a copper conductor paste containing copper powder, glass powder, an organic vehicle, or other components and firing the paste to form a copper conductor in the through-hole (for example, Patent Literature 2 below and other publications).

### Citation List

### Patent Literatures

Patent Literature 1: Japanese Unexamined Patent Publication No. 2019-16712
Patent Literature 2: Japanese Unexamined Patent Publication No. 2010-108917

### Summary of Invention

### Technical Problem

Recently, the inner diameter of a through-hole has been minimized along with the reduction of a silicon substrate for coping with the miniaturization of electronic devices or components, and it is necessary to form a conductive via having sufficient conductivity even in such a through-hole. In addition, a wiring may be further provided on a surface of the substrate in which the conductive via is formed by plating or other processes, and even in this case, it is necessary to exhibit a sufficiently low connection resistance value.

Therefore, an object of the present invention is to provide a method for manufacturing a conductive via-containing substrate capable of obtaining a conductive via-containing substrate exhibiting a sufficiently low connection resistance value even after wiring formation, a metal paste capable of being used in the method, and a conductive via-containing substrate.

### Solution to Problem

As a result of intensive studies to achieve the above-described object, the present inventors have found that a factor of increasing the connection resistance value after wiring formation is a low planarity (or smoothness) of conductive vias at a surface of a conductive via-containing substrate (in other words, the step height between a conductive via part and the substrate surface is large). As a result of studying a method for reducing the above-described step height based on this finding, the present inventors have found that a sufficiently low connection resistance value can be obtained by forming a conductive via by a specific step using a metal paste containing specific metal particles and a volatile solvent even in a case where a wiring connected to the conductive via is further formed, and have completed the present invention.

That is, one aspect of the present invention relates to a method for manufacturing a conductive via-containing substrate described below.
[1] A method for manufacturing a conductive via-containing substrate, the method including:
   step a of preparing a substrate provided with a hole and providing a metal paste part containing metal particles and a volatile solvent to cover at least a surface surrounding the hole of the substrate while an inside of the hole is filled with the metal paste part;
   step b of heating the metal paste part to remove a part of the volatile solvent;
   step c of removing a part of the metal paste part after heating to expose the surface to form a conductive via precursor in the hole, the conductive via precursor containing the metal particles and a residue of the volatile solvent and having a planarized exposed surface; and
   step d of firing the conductive via precursor to form a conductive via, in which
   the metal particles include first copper particles having an average particle diameter of 0.8 µm or more, second copper particles having an average particle diameter of 0.5 µm or less, and solder particles, and
   the metal particles in the metal paste part provided in step a have a concentration of 94% by mass or more.

According to the above manufacturing method, it is possible to provide, through step a, the metal paste part containing the volatile solvent and having the above-described specific metal particle configuration, and then through step b and step c, to achieve both the good filling of the inside of the hole and the formation of the conductive via precursor that is less likely to undergo volume shrinkage by firing, and it is possible to form, through step d, the conductive via with excellent conductivity, in which the occurrence of cracks and voids is sufficiently minimized while the step height with respect to the substrate surface is sufficiently reduced. As a result, it is possible to obtain a conductive via-containing substrate, exhibiting a sufficiently low connection resistance value, even after wiring formation.

In addition, another aspect of the present invention relates to the following metal paste.

[2] A metal paste including:
metal particles; and
a volatile solvent, in which
the metal particles include first copper particles having an average particle diameter of 0.8 µm or more, second copper particles having an average particle diameter of 0.4 µm or less, and solder particles, and
the metal particles have a concentration of 94% by mass or more.

[3] The metal paste according to [2], in which the first copper particles contain a wet copper powder and an atomized copper powder.

[4] The metal paste according to [2] or [3], in which the volatile solvent contains a high vapor pressure solvent having a vapor pressure of 4 Pa or more and 30 Pa or less at 20°C.

[5] The metal paste according to [4], in which the volatile solvent further contains a low vapor pressure solvent having a vapor pressure of less than 4 Pa at 20°C.

[0012] According to the metal paste, the sufficient printability can be obtained, and the metal paste part can be efficiently formed in the method for manufacturing a conductive via-containing substrate.

[0013] In addition, another aspect of the present invention relates to the following conductive via-containing substrate.

[6] A conductive via-containing substrate including:
a substrate having a through-hole; and
a conductive via part provided in the through-hole, in which
the conductive via part contains a sintered body containing the metal paste according to any one of [2] to [5].

[7] A conductive via-containing substrate including:
a substrate having a through-hole, and
a conductive via part provided in the through-hole, in which
the conductive via part contains a metal body including a copper sintered body having a porous structure, a solder present in the copper sintered body in an interspersed manner, and pores, and
an average step height between a surface of the substrate and the conductive via part is 5 µm or less.

### Advantageous Effects of Invention

According to the present invention, it is possible to provide a method for manufacturing a conductive via-containing substrate capable of obtaining a conductive via-containing substrate exhibiting a sufficiently low connection resistance value even after wiring formation, and a metal paste capable of being used in the method.

### Brief Description of Drawings

FIG. 1 is a schematic diagram illustrating an example of a method for manufacturing a conductive via-containing substrate according to the present embodiment.
FIG. 2 is a schematic diagram illustrating an example of the method for manufacturing a conductive via-containing substrate according to the present embodiment.
FIG. 3 is a schematic diagram illustrating an example of the method for manufacturing a conductive via-containing substrate according to the present embodiment.
FIG. 4 is a schematic diagram illustrating an example of a method for forming a wiring.
FIG. 5 is a schematic diagram illustrating a test piece.
FIG. 6 is a cross-section photograph of a conductive via in a conductive via-containing silicon substrate produced in Example 1.
FIG. 7 is a cross-section photograph of a conductive via in a sample produced in Example 1.
FIG. 8 is a cross-section photograph of a portion with a crack inside a conductive via in a sample produced in Comparative Example 2.

### Description of Embodiments

Hereinafter, embodiments of the present invention will be described in detail with reference to the drawings. The present invention is not limited to the following embodiments. In the drawings, the same or corresponding parts are denoted by the same reference numerals, and redundant description will be omitted.

### <Metal Paste>

A metal paste of the present embodiment contains metal particles and a volatile solvent, and the concentration of the metal particles is 94% by mass or more. The metal paste of the present embodiment can be used for forming a metal paste part in a method for manufacturing a conductive via-containing substrate described later.

The concentration of the metal particles in the metal paste of the present embodiment may be 92% by mass or more, 94% by mass or more, or 95% by mass or more, and may be 98% by mass or less, 97% by mass or less, or 96% by mass or less.

### [Metal Particles]

Examples of the metal particles include particles of nickel, silver, copper, gold, palladium, platinum, solder, and other metals. In a case where the metal paste contains copper particles and solder particles, it is easy to obtain a conductor having sufficient conductivity and a resistance value that does not easily increase even under temperature changes, and a base having a through electrode with sufficient conductivity and excellent connection reliability. In the present embodiment, the metal particles include first copper particles having an average particle diameter of 0.8 µm or more, second copper particles having an average particle diameter of 0.4 µm or less, and solder particles.

In the present specification, the average particle diameter of particles means a 50% volume average particle diameter (D50). In a case where the volume average particle diameter of the metal particles is determined, the volume average particle diameter can be determined by a method for dispersing metal particles as a raw material in a dispersion medium such as water or alcohol, and measuring the dispersion medium with a laser diffraction/scattering particle size distribution analyzer, or other ways.

### (First Copper Particles)

The average particle diameter of the first copper particles may be 0.8 µm or more, 1.0 µm or more, 2.0 µm or more, or 3.0 µm or more from the viewpoint of improving the sintering density in the holes (for example, through-holes or blind-holes) of the substrate and minimizing voids and cracks occurring in the holes, the average particle diameter of the first copper particles may be 10 µm or less, 8.0 µm or less, 5.0 µm or less, or 4.0 µm or less, for example, from the viewpoint of minimizing clogging of the particles in a fine via having an inner diameter of 50 µm or less and improving the fillability, and the average particle diameter of the first copper particles may be 0.8 µm to 4.0 µm, 1.0 µm to 3.5 µm, or 1.2 µm to 3.0 µm from the viewpoint of minimizing voids and cracks and minimizing clogging of the particles in the fine via.

The shape of the first copper particles may be, for example, a spherical shape, an agglomerated shape, a needle shape, a flat shape (flake shape), a substantially spherical shape, or other shapes. The first copper particles may be an aggregate of copper particles having these shapes. The metal paste of the present embodiment can contain spherical copper particles as the first copper particles from the viewpoint of reducing the step height between the conductive via part to be formed and the substrate surface to minimize the fluctuation in connection resistance even after a reliability test (for example, a temperature cycle test).

In the first copper particles, the content ratio of particles having an aspect ratio of 2 or less, such as spherical particles, may be 60% by mass or more, 80% by mass or more, or 100% by mass from the viewpoint of improving the printability of the metal paste. The aspect ratio (major axis/minor axis) of a particle can be determined, for example, by observing an SEM image of the particle and measuring the major axis and the minor axis (for example, the thickness).

The first copper particles may be produced by a chemical reduction method, an atomization method, an electrolytic method, a pulverization method, a plasma rotating electrode process, a homogeneous liquid spraying method, a heat treatment method, or other methods, and may be wet copper powder or atomized copper powder from the viewpoint of easily obtaining a uniform diameter and improving the dispersibility of the metal paste.

The first copper particles may include a wet copper powder. In this case, a conductive via having excellent conductivity is easily obtained. Such an effect is considered to be obtained based on the properties of the wet copper powder being easily bonded to the second copper particles. The wet copper powder may have a D90/D50 of 1.5 or less.

In addition, the first copper particles can contain a wet copper powder and an atomized copper powder. In this case, it is easy to achieve that the printability of the metal paste is improved, and the step height between the conductive via part to be formed and the substrate surface is reduced to minimize the fluctuation in connection resistance even after a reliability test (for example, a temperature cycle test). The reason why such an effect can be obtained is presumed as follows. That is, it is considered that since the wet copper powder that is easily bonded to the second copper particles and that has a uniform particle diameter and the atomized copper powder that has a wide particle size distribution coexist, particles of the wet copper powder are bonded to the second copper particles while bonding between particles of the atomized copper powder. As a result, it is possible to achieve the formation of a strong sintered body based on the close-packed structure, and the reduction of shrinkage during sintering to minimize the occurrence of voids and cracks and minimize recesses. The atomized copper powder may have a D90/D50 of 1.6 or more, 1.7 or more, or 1.8 or more.

In a case where the first copper particles contain the wet copper powder and the atomized copper powder, the proportional content of the wet copper powder may be more than 0 parts by mass and less than 100 parts by mass, or may be 20 to 80 parts by mass, with respect to a total of 100 parts by mass of the wet copper powder and the atomized copper powder.

As the first copper particles, commercially available copper particles can be used. Examples of the first copper particles, which are commercially available, include 1050Y (manufactured by MITSUI MINING & SMELTING CO., LTD., trade name, average particle diameter (D50): 0.81 µm, D90: 1.1 µm, spherical shape, wet copper powder), 1100Y (manufactured by MITSUI MINING & SMELTING CO., LTD., trade name, average particle diameter (D50): 1.1 µm, D90: 1.6 µm, spherical shape, wet copper powder), 1200Y (manufactured by MITSUI MINING & SMELTING CO., LTD., trade name, average particle diameter (D50): 2.1 µm, D90: 3.1 µm, spherical shape, wet copper powder), 1300Y (manufactured by MITSUI MINING & SMELTING CO., LTD., trade name, average particle diameter (D50): 3.5 µm, D90: 5 µm, spherical shape, wet copper powder), 1100YP (manufactured by MITSUI MINING & SMELTING CO., LTD., trade name, average particle diameter (D50): 1.4 µm, D90: 2.3 µm, flat shape, wet copper powder), 1200YP (manufactured by MITSUI MINING & SMELTING CO., LTD., trade name, average particle diameter (D50): 3.1 µm, D90: 5.3 µm, flat shape, wet copper powder), MA-C02K (manufactured by MITSUI MINING & SMELTING CO., LTD., trade name, average particle diameter (D50): 1.8 µm, D90: 3.6 µm, spherical shape, atomized copper powder), MA-C025K (manufactured by MITSUI MINING & SMELTING CO., LTD., trade name, average particle diameter (D50): 2.4 µm, D90: 5.2 µm, spherical shape, atomized copper powder), and MA-C03K(manufactured by MITSUI MINING & SMELTING CO., LTD., trade name, average particle diameter (D50): 3.4 µm, D90: 6.3 µm, spherical shape, atomized copper powder).

The first copper particles may have been treated with a surface treatment agent from the viewpoint of dispersion stability and oxidation resistance. The surface treatment agent may be removed during wiring formation (during sintering of copper particles). Examples of such a surface treatment agent include aliphatic carboxylic acids such as palmitic acid, stearic acid, arachidic acid, and oleic acid; aromatic carboxylic acids such as terephthalic acid, pyromellitic acid, and o-phenoxybenzoic acid; aliphatic alcohols such as cetyl alcohol, stearyl alcohol, isobornyl cyclohexanol, and tetraethylene glycol; aromatic alcohol such as p-phenylphenol; alkylamines such as octylamine, dodecylamine, and stearylamine; aliphatic nitriles such as stearonitrile and decanenitrile; silane coupling agents such as alkylalkoxysilane; polymer treatment agents such as polyethylene glycol, polyvinyl alcohol, polyvinyl pyrrolidone, and silicone oligomers, and other surface treatment agents. The surface treatment agent may be used alone or in combination of two or more kinds thereof.

The amount of the surface treatment agent may be an amount of a monolayer or more multilayer on a particle surface. The amount of such a surface treatment agent varies depending on the specific surface area of the first copper particles, the molecular weight of the surface treatment agent, and the minimum coating area of the surface treatment agent. The amount of the surface treatment agent is usually 0.001% by mass or more.

The amount of the surface treatment agent can be calculated from the number of molecular layers (n) attached to the surface of a first copper particle, a specific surface area of the first copper particles (Aₚ) (unit: m²/g), a molecular weight of the surface treatment agent (Mₛ) (unit: g/mol), a minimum coating area of the surface treatment agent (S_{S}) (unit: m²/unit), and the Avogadro's number (N_{A}) (6.02 × 10²³). Specifically, the amount of the surface treatment agent is calculated according to the equation represented by the amount of the surface treatment agent (% by mass) = {(n × Aₚ × Mₛ)/(S_{S} × N_{A} + n × Aₚ × Mₛ)} × 100%.

The specific surface area of the first copper particles can be calculated by measuring the dried copper particles with the BET specific surface area measurement method. In a case where the surface treatment agent is a linear saturated fatty acid, the minimum coating area of the surface treatment agent is 2.05 × 10⁻¹⁹ m²/1 molecule. For other surface treatment agents, for example, the minimum coating area can be measured by calculation from a molecular model or the method described in "Chemistry and Education" (Katsuhiro Ueda, Sumio Inafuku, and Iwao Mori, 40 (2), 1992, pp 114-117). An example of a method for quantifying the surface treatment agent will be described. The surface treatment agent can be identified using the dry powder obtained by removing the dispersion medium from the metal paste by a thermal desorption gas-gas chromatograph mass spectrometer, thereby enabling the number of carbon atoms and the molecular weight of the surface treatment agent to be determined. The proportion of carbon content in the surface treatment agent can be analyzed by carbon content analysis. Examples of the carbon content analysis method include a highfrequency induction heating furnace combustion-infrared absorption method. The surface treatment agent amount can be calculated from the number of carbon atoms, the molecular weight, and the proportion of carbon content of the identified surface treatment agent by the above described equation.

### (Second Copper Particles)

The average particle diameter of the second copper particles may be 0.4 µm or less, 0.3 µm or less, or 0.2 µm or less from the viewpoint of sinterability, may be 0.01 µm or more, 0.03 µm or more, 0.05 µm or more, 0.08 µm or more, or 0.1 µm or more from the viewpoint of reducing synthesis cost, good dispersibility, reducing the use amount of a surface treatment agent, and may be 0.1 µm to 0.3 µm, 0.12 µm to 0.28 µm, or 0.15 µm to 0.25 µm from the viewpoint of obtaining sinterability at a low temperature and good dispersibility in a paste.

The second copper particles can act as copper particles that suitably bond between the first copper particles. In addition, the second copper particles are more excellent in sinterability than the first copper particles, and can have a function of promoting sintering of the copper particles. For example, the copper particles can be sintered at a lower temperature as compared to a case where the first copper particles are used alone as the copper particles.

The second copper particles may be a wet copper powder produced by a chemical reduction method.

The shape of the second copper particles may be, for example, a spherical shape, an agglomerated shape, a needle shape, a flat shape (flake shape), a substantially spherical shape, or other shapes. The second copper particles may be an aggregate of copper particles having these shapes. From the viewpoint of the dispersibility and the fillability, the shape of the second copper particles may be a spherical shape, a substantially spherical shape, or a flat shape(flake shape), and from the viewpoint of the flammability, the mixability with the first copper particles, and other properties, the shape may be a spherical shape or a substantially spherical shape.

The aspect ratio of the second copper particles may be 5 or less, 4 or less, or 3 or less from the viewpoint of the dispersibility, the fillability, and the mixability with the first copper particles.

As the second copper particles, synthesized or commercially available copper particles can be used. Examples of the second copper particles, which are commercially available, include CH0200L1 (manufactured by MITSUI MINING & SMELTING CO., LTD., trade name, average particle diameter (D50): 200 nm, spherical) and Tn-Cu100 (manufactured by TAIYO NIPPON SANSO CORPORATION, average particle diameter (D50): 120 nm, spherical).

The second copper particles may have been treated with a particular surface treatment agent. Examples of the specific surface treatment agent include an organic acid having 8 to 16 carbon atoms. Examples of the organic acid having 8 to 16 carbon atoms include saturated fatty acids such as caprylic acid, methylheptanoic acid, ethylhexanoic acid, propylpentanoic acid, pelargonic acid, methyloctanoic acid, ethylheptanoic acid, propylhexanoic acid, capric acid, methylnonanoic acid, ethyloctanoic acid, propylheptanoic acid, butylhexanoic acid, undecanoic acid, methyldecanoic acid, ethylnonanoic acid, propyloctanoic acid, butylheptanoic acid, lauric acid, methylundecanoic acid, ethyldecanoic acid, propylnonanoic acid, butyloctanoic acid, pentylheptanoic acid, tridecanoic acid, methyldodecanoic acid, ethylundecanoic acid, propyldecanoic acid, butylnonanoic acid, pentyloctanoic acid, myristic acid, methyltridecanoic acid, ethyldodecanoic acid, propylundecanoic acid, butyldecanoic acid, pentylnonanoic acid, hexyloctanoic acid, pentadecanoic acid, methyltetradecanoic acid, ethyltridecanoic acid, propyldodecanoic acid, butylundecanoic acid, pentyldecanoic acid, hexylnonanoic acid, palmitic acid, methylpentadecanoic acid, ethyltetradecanoic acid, propyltridecanoic acid, butyldodecanoic acid, pentylundecanoic acid, hexyldecanoic acid, heptylnonanoic acid, methylcyclohexanecarboxylic acid, ethylcyclohexanecarboxylic acid, propylcyclohexanecarboxylic acid, butylcyclohexanecarboxylic acid, pentylcyclohexanecarboxylic acid, hexylcyclohexanecarboxylic acid, heptylcyclohexanecarboxylic acid, octylcyclohexanecarboxylic acid, and nonylcyclohexanecarboxylic acid; unsaturated fatty acids such as octenoic acid, nonenoic acid, methylnonenoic acid, decenoic acid, undecenoic acid, dodecenoic acid, tridecenoic acid, tetradecenoic acid, myristoleic acid, pentadecenoic acid, hexadecenoic acid, palmitoleic acid, and sapienic acid; and aromatic carboxylic acids such as terephthalic acid, pyromellitic acid, o-phenoxybenzoic acid, methyl benzoic acid, ethyl benzoic acid, propyl benzoic acid, butyl benzoic acid, pentyl benzoic acid, hexyl benzoic acid, heptyl benzoic acid, octyl benzoic acid, and nonyl benzoic acid. The organic acid may be used alone or in combination of two or more kinds thereof. Both the dispersibility of the second copper particles and the removability of the organic acid during the sintering both are likely to be compatible by a combination of such an organic acid with the above-described second copper particles.

The amount of the surface treatment agent may be an amount of a monolayer to a trilayer adhering to the surface of a second copper particle. The amount of the surface treatment agent may be 0.07% by mass or more, 0.10% by mass or more, or 0.2% by mass or more, and may be 2.1% by mass or less, 1.6% by mass or less, or 1.1% by mass or less. The surface treatment amount of the second copper particles can be calculated by the method described above for the first copper particles. The same applies to the specific surface area, the molecular weight of the surface treatment agent, and the minimum coating area of the surface treatment agent.

The total content of the first copper particles and the second copper particles in the metal paste may be 85 to 99.5 parts by mass, 90 to 99 parts by mass, or 95 to 98 parts by mass, given that the total mass of the metal particles is 100 parts by mass.

A content of each of the first copper particles and the second copper particles may be 5 to 95 parts by mass and 95 to 5 parts by mass, 20 to 80 parts by mass and 80 to 20 parts by mass, or 30 to 70 parts by mass and 70 to 30 parts by mass, with respect to a total of 100 parts by mass of the first copper particles and the second copper particles.

### (Solder Particles)

The solder particles containing tin or a tin alloy can be used. As the tin alloy, for example, In-Sn, In-Sn-Ag, Sn-Bi, Sn-Bi-Ag, Sn-Ag-Cu, or Sn-Cu-based alloys can be used, and the following examples can be mentioned.
- In-Sn (52% by mass of In, 48% by mass of Sn, melting point: 118°C)
- In-Sn-Ag (20% by mass of In, 77.2% by mass of Sn, 2.8% by mass of Ag, melting point: 175°C)
- Sn-Bi (43% by mass of Sn, 57% by mass of Bi, melting point: 138°C)
- Sn-Bi-Ag (42% by mass of Sn, 57% by mass of Bi, 1% by mass of Ag, melting point: 139°C)
- Sn-Ag-Cu (96.5% by mass of Sn, 3% by mass of Ag, 0.5% by mass of Cu, melting point: 217°C)
- Sn-Cu (99.3% by mass of Sn, 0.7% by mass of Cu, melting point: 227°C)

The average particle diameter of the solder particles may be 1.0 µm or more, 1.5 µm or more, 2.0 µm or more, 3.0 µm or more, or 4.0 µm or more from the viewpoint of reducing volume shrinkage caused by sintering in the holes to minimize voids occurring in the through-holes, may be 15 µm or less, 10 µm or less, 8.0 µm or less, or 5.0 µm or less from the viewpoint of making the distribution of the solder particles in the holes more uniform and reducing the size of the voids occurring in the vicinity of the solder particles, and may be 2.0 µm to 8.0 µm, 2.5 µm to 7.0 µm, or 3.0 µm to 6.0 µm from the viewpoint of reducing volume shrinkage, and improving the dispersion of the solder particles to make the size of the voids as small as possible for dispersion. Since the solder particles have such a particle diameter, volume shrinkage that occurs during the sintering of the conductive via precursor described later can be sufficiently reduced, and it is easy to form a conductive via part having a porous structure and a sufficiently formed conductive network in the holes while reducing the step height with respect to the substrate surface. As a result, a sufficiently low connection resistance value can be exhibited even after wiring formation, and disconnection caused by thermal stress of the wiring can be further reduced.

The shape of the solder particles may be, for example, a spherical shape, an agglomerated shape, a needle shape, a flat shape (flake shape), a substantially spherical shape, or other shapes. The solder particles may be an aggregate of solder particles having these shapes.

The solder particles are preferably spherical. In this case, the solder is uniformly dispersed inside the metal body, and void spaces are generated inside the solder uniformly dispersed or at the outer peripheral portion of the solder (between the solder and the copper sintered body). As a result, volume shrinkage during the sintering of the conductive via precursor described later is reduced, and disconnection caused in the conductive via part can be easily reduced.

The content of the solder particles in the metal paste may be 0.3 to 15 parts by mass, 1 to 10 parts by mass, or 2 to 5 parts by mass, given that the total mass of the metal particles is 100 parts by mass.

In addition, the content of the solder particles may be 0.2 to 13 parts by mass, 0.8 to 9 parts by mass, or 1.5 to 4 parts by mass with respect to a total of 100 parts by mass of the first copper particles and the second copper particles contained in the metal paste. In a case where the content of the solder particles is within the above-described range, it is easy to form a conductive via having a porous structure and a sufficiently formed conductive network while the occurrence of voids and cracks in the holes is minimized.

The metal paste of the present embodiment may contain metal particles other than the copper particles and the solder particles (hereinafter, also referred to as "other metal particles"). Examples of the other metal particles include nickel particles, silver particles, gold particles, palladium particles, and platinum particles. These can be contained singly or in combination of two or more kinds thereof. The average particle diameter of the other metal particles may be 0.01 µm or more, 0.03 µm or more, or 0.05 µm or more, and may be 5 µm or less, 3.0 µm or less, or 2.0 µm or less. The content of the other metal particles may be 5 parts by mass or less, 3 parts by mass or less, or 1 part by mass or less, given that the total mass of the metal particles is 100 parts by mass. The other metal particles may not be contained. The shape of the other metal particles is not particularly limited.

### [Volatile Solvent]

Examples of the volatile solvent include monohydric and polyhydric alcohols such as pentanol, hexanol, heptanol, octanol, decanol, ethylene glycol, diethylene glycol, propylene glycol, butylene glycol (such as 1,3-butanediol), α-terpineol, and isobornyl cyclohexanol (MTPH); ethers such as ethylene glycol butyl ether, ethylene glycol phenyl ether, diethylene glycol methyl ether, diethylene glycol ethyl ether (ethyl carbitol), diethylene glycol butyl ether (such as diethylene glycol mono-n-butyl ether), diethylene glycol isobutyl ether, diethylene glycol hexyl ether, triethylene glycol methyl ether, diethylene glycol dimethyl ether, diethylene glycol diethyl ether, diethylene glycol dibutyl ether, diethylene glycol butyl methyl ether, diethylene glycol isopropyl methyl ether, triethylene glycol dimethyl ether, triethylene glycol butyl methyl ether, propylene glycol propyl ether, dipropylene glycol methyl ether, dipropylene glycol ethyl ether, dipropylene glycol propyl ether, dipropylene glycol butyl ether, dipropylene glycol dimethyl ether, tripropylene glycol methyl ether, tripropylene glycol dimethyl ether; esters such as dimethyl phthalate, ethylene glycol ethyl ether acetate, ethylene glycol butyl ether acetate, propylene glycol diacetate, diethylene glycol ethyl ether acetate, diethylene glycol butyl ether acetate, dipropylene glycol methyl ether acetate (DPMA), ethyl lactate, butyl lactate, γ-butyrolactone, and propylene carbonate; acid amides such as N-methyl-2-pyrrolidone, N,N-dimethylacetamide, and N,N-dimethylformamide; aliphatic hydrocarbons such as cyclohexane, octane, nonane, decane, and undecane; aromatic hydrocarbons such as benzene, toluene, and xylene; mercaptans containing an alkyl group having 1 to 18 carbon atoms; and mercaptans containing a cycloalkyl group having 5 to 7 carbon atoms. Examples of the mercaptans containing an alkyl group having 1 to 18 carbon atoms include ethyl mercaptan, n-propyl mercaptan, i-propyl mercaptan, n-butyl mercaptan, i-butyl mercaptan, t-butyl mercaptan, pentyl mercaptan, hexyl mercaptan, and dodecyl mercaptan. Examples of the mercaptans containing a cycloalkyl group having 5 to 7 carbon atoms include cyclopentyl mercaptan, cyclohexyl mercaptan, and cycloheptyl mercaptan. The volatile solvent may be used alone or in combination of two or more kinds thereof.

The metal paste of the present embodiment may contain a solvent having a vapor pressure of 4 Pa or more and 30 Pa or less (hereinafter, also referred to as a "high vapor pressure solvent") at 20°C as a volatile solvent from the viewpoint of printability and reducing volume shrinkage before and after firing the conductive via precursor (for example, between step C of forming the conductive via precursor and step d of firing the conductive via precursor) to minimize voids and cracks. The high vapor pressure solvent may be used alone or in combination of two or more kinds thereof.

Examples of the high vapor pressure solvent include α-terpineol, 1,3-butanediol, ethyl carbitol, propylene glycol diacetate, and other high vapor pressure solvents.

The metal paste of the present embodiment may contain a solvent having a vapor pressure of less than 4 Pa (hereinafter, also referred to as a "low vapor pressure solvent") at 20°C as a volatile solvent from the viewpoint of minimizing powderization by drying associated with solvent evaporation during printing or paste production. The low vapor pressure solvent may be used alone or in combination of two or more kinds thereof.

Examples of the low vapor pressure solvent include isobornyl cyclohexanol (MTPH), dimethyl phthalate, diethylene glycol mono-n-butyl ether, and other low vapor pressure solvents.

The metal paste of the present embodiment may contain the high vapor pressure solvent and the low vapor pressure solvent from the viewpoint of achieving compatibility of printability and reducing volume shrinkage before and after firing the conductive via precursor (for example, between step C of forming the conductive via precursor and step d of firing the conductive via precursor) to minimize voids and cracks. In this case, each of the high vapor pressure solvent and the low vapor pressure solvent may be used alone or in combination of two or more kinds thereof. The content ratio of the high vapor pressure solvent to the low vapor pressure solvent may be 20/80 to 80/20 or may be 30/70 to 70/30, by mass ratio of [high vapor pressure solvent/low vapor pressure solvent].

The content of the volatile solvent in the metal paste of the present embodiment may be 8% by mass or more, 7% by mass or more, or 6% by mass or more, and may be 1% by mass or less, 2% by mass or less, or 3% by mass or less based on the total mass of the metal paste.

The metal paste of the present embodiment may contain a resin component such as an epoxy resin. The metal paste of the present embodiment may have a content of the resin component of 10% by mass or less, 5% by mass or less, or may not contain a resin component.

The metal paste can be prepared by mixing the above-described copper particles, solder particles, and any components (such as additives and other metal particles) with the above-described volatile solvent. After mixing the components, a stirring treatment may be carried out. In a dispersion, the maximum diameter may be adjusted by a classification operation.

In a case where the metal paste contains the first copper particles and second particles described above, the second copper particles, the surface treatment agent, and the dispersion medium are mixed in advance, and a dispersion treatment is carried out to prepare a dispersion of the second copper particles, and the first copper particles, the solder particles, the other metal particles as necessary, and any additives may be further mixed to complete the preparation. According to such a procedure, the dispersibility of the second copper particles is improved, the mixability with the first copper particles is improved, and the performance of the metal paste is further improved. The dispersion of the second copper particles may be subjected to a classification operation to remove an aggregation substance.

The metal paste of the present embodiment may have a viscosity of 100 to 600 Pa·s, or 150 to 400 Pa·s at 25°C from the viewpoint of printability. The viscosity of the metal paste is measured by using a micro spiral viscometer PCU-02V (manufactured by Malcom Co., Ltd., product name) under conditions of a rotation speed of 10 rpm and a temperature of 25°C.

<Method for Manufacturing Conductive via-Containing Substrate>

A method for manufacturing a conductive via-containing substrate of the present embodiment includes step a of preparing a substrate provided with a hole and providing a metal paste part containing metal particles and a volatile solvent to cover at least a surface surrounding the hole of the substrate while an inside of the hole is filled with the metal paste part; step b of heating the metal paste part to remove a part of the volatile solvent; step c of removing a part of the metal paste part after heating to expose the surface to form a conductive via precursor in the hole, the conductive via precursor containing the metal particles and a residue of the volatile solvent and having a planarized exposed surface; and step d of firing the conductive via precursor to form a conductive via, in which the metal particles include first copper particles having an average particle diameter of 0.8 µm or more, second copper particles having an average particle diameter of 0.5 µm or less, and solder particles, and the metal particles in the metal paste part provided in step a have a concentration of 94% by mass or more.

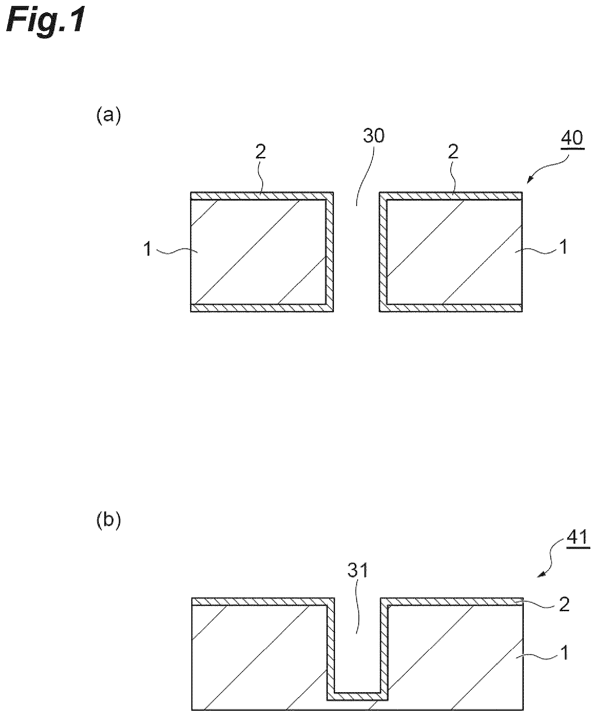

FIGS. 1 to 3 are schematic diagrams illustrating an example of the method for manufacturing a conductive via-containing substrate according to the present embodiment. FIG. 1 illustrates an example of a substrate used in a method for manufacturing a conductive via-containing substrate. Hereinafter, the method for manufacturing a conductive via-containing substrate according to the present embodiment will be described with reference to these drawings.

### [Step a]

Examples of the substrate provided with a hole prepared in this step include a silicon substrate, a glass substrate, a ceramic substrate, a printed wiring board, a semiconductor package substrate, and other substrates. The hole may be a through-hole or a blind-hole. In the present embodiment, for example, as illustrated in FIG. 1(a), it is possible to prepare a silicon substrate 40 including a silicon wafer 1 provided with a through-hole 30 and a metal coating 2 provided on a wall surface of the through-hole and surfaces of the silicon wafer 1. The through-hole 30 penetrates through both main surfaces of the silicon substrate 40. Although a case where a conductive via is provided in the silicon substrate 40 will be described as an example, the silicon wafer may be replaced with another insulating base in the following description.

The thickness of a silicon wafer 1 may be 100 µm or more, 200 µm or more, or 300 µm or more from the viewpoint of minimizing warpage of a substrate after sintering, and may be 800 µm or less, 300 µm or less, 200 µm or less, or 100 µm or less from the viewpoint of weight reduction and high density of a substrate.

The upper limit value of the hole diameter of the through-hole 30 may be 200 µm or less, 100 µm or less, or 60 µm or less from the viewpoint of achieving a high density of a semiconductor device to be obtained, and the lower limit value of the hole diameter of the through-hole 30 is not particularly limited, but may be 20 µm or more, 30 µm or more, or 50 µm or more.

The number of through-holes 30 provided in the silicon substrate 40 may be 100 or more, 200 or more, or 300 or more per 1 cm² of the main surface of the substrate from the viewpoint of achieving a high density of a semiconductor device to be obtained.

The metal coating 2 may be provided on both main surfaces of the silicon wafer 1 and the wall surface of the through-hole 30, may be provided on at least one main surface of the silicon wafer 1 and the wall surface of the through-hole 30, may be provided on the wall surface of the through-hole 30 alone, or may not be provided. In the embodiment illustrated in FIG. 1(a), the silicon substrate 40 is provided with the metal coating 2 on both main surfaces of the silicon wafer 1 and the wall surface of the through-hole 30.

Examples of the metal coating 2 include titanium, nickel, chromium, copper, aluminum, palladium, platinum, gold, and other metal material. From the viewpoint of adhesion, the metal coating 2 is preferably a coating with titanium, nickel, and copper layered in this order. The surface of the silicon wafer 1 is oxidized to form silicon oxide, and a titanium layer is formed on the silicon oxide, thereby improving adhesiveness. In addition, a nickel layer is provided on the titanium layer, and a copper layer is provided thereon to reduce diffusion of copper into the silicon wafer 1 as compared to a case where the copper layer is directly provided on the titanium layer. Furthermore, the copper layer is provided on the surface to improve the adhesion between the copper layer and the copper particles in the metal paste, resulting in the improvement on the reliability.

As illustrated in FIG. 1(b), in a case of preparing a silicon substrate 41 provided with a blind-hole 31 as a hole, a conductive via serving as a through electrode can be formed by grinding a surface of the silicon substrate opposite to the surface to which the blind-hole 31 is opened, after step a, step b, step c, or step d. Examples of the grinding method include mechanical polishing, chemical mechanical polishing, and other grinding methods.

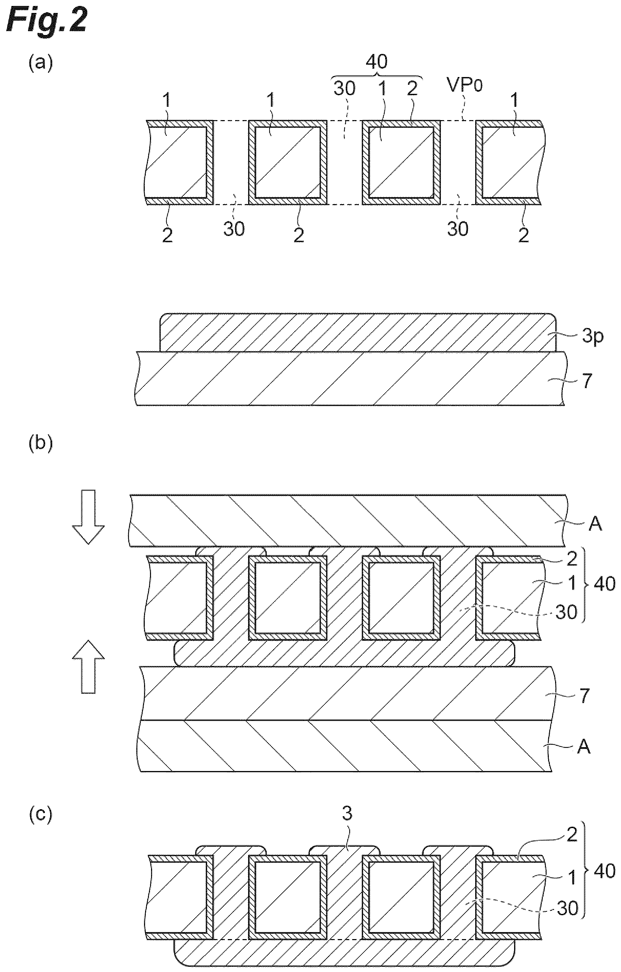

As illustrated in FIGS. 2(a) to 2(c), the metal paste part 3 can be provided, for example, by producing a metal particle film in which a metal particle-containing layer 3p made of the metal paste of the present embodiment described above is provided on a support film 7, and pressing the metal particle film against the substrate.

Examples of the support film 7 include a polyimide film, a polyethylene naphthalate film, a polyethylene terephthalate film, and other support films. The thickness of the support film may be 20 to 200 µm, 25 to 175 µm, or 30 to 150 µm from the viewpoint of workability for forming the metal particle-containing layer by coating.

The compositions of metal particles and a volatile solvent in the metal particle-containing layer can be appropriately set such that the conditions in the metal paste of the present embodiment described above are satisfied. The thickness of the metal particle-containing layer may be 100 µm or less. From the viewpoint of easily ensuring sufficient fillability of through-holes or blind-holes, the thickness of the metal particle-containing layer may be 30 µm or more, 40 µm or more, or 50 µm or more.

From the viewpoint of minimizing the occurrence of voids in the through-holes or the blind-holes, the metal particle-containing layer may have an undulation (height difference) of 20 µm or less or 10 µm or less on the surface opposite to the support film. As the undulation (height difference) is reduced, it is easy to fill a large number of through-holes or blind-holes present in the base all at once when the metal particle film is pressed to fill the holes of the base with a metal particle composition, and it is easy to reduce completely unfilled through-holes or blind-holes and through-holes or non-through-holes in which voids partially occur. The evaluation of the undulation (height difference) can be measured by a non-contact method using a laser displacement meter or other instruments.

The metal particle film described above can be produced by applying the metal paste of the present embodiment described above on a support film to form a metal particle-containing layer having a concentration of metal particles of 94% by mass or more, or applying a metal paste having an increased content of a volatile solvent (for example, the concentration of the metal particles is increased to an amount of less than 92% by mass), and drying a coating film to form a metal particle-containing layer having a concentration of metal particles of 94% by mass or more.

Examples of the method for applying the metal paste include application methods by using screen printing, transfer printing, offset printing, a jet printing method, a dispenser, a jet dispenser, a needle dispenser, a comma coater, a slit coater, a die coater, a gravure coater, slit coating, relief printing, intaglio printing, gravure printing, stencil printing, soft lithography, bar coating, an applicator, a particle deposition method, a spray coater, a spin coater, a dip coater, or other application methods.

From the viewpoint of coating workability and uniformity of the thickness of the coating film, the metal paste can be applied onto the support film by screen printing.

The thickness of the coating film may be 1 µm or more, 2 µm or more, 3 µm or more, 5 µm or more, 10 µm or more, 15 µm or more, or 20 µm or more, and may be 300 µm or less, 250 µm or less, 200 µm or less, 150 µm or less, 120 µm or less, 100 µm or less, 80 µm or less, or 50 µm or less.

The step of drying the coating film to form the metal particle-containing layer can be performed at normal temperature or a temperature of normal temperature to 100°C or lower, and the atmosphere may be in the ambient atmosphere or in the nitrogen.

In step a, the above-described metal particle film is pressed against the silicon substrate 40 so that the metal particle-containing layer 3p of the metal particle film is brought into contact with the silicon substrate 40 to fill the through-hole 30 of the silicon substrate 40 with the metal paste. In this case, for example, as illustrated in FIG. 2(b), the metal particle film and the silicon substrate 40 can be sandwiched and pressurized by a pressure jig A from above and below. The pressure jig A is not particularly limited, but may be a commercially available one, and may be manufactured by using a metal member with a flat part. For example, a pressure jig including two or more metal members can press the metal particle film against the silicon substrate by sandwiching the metal particle film and the silicon substrate between the metal members arranged such that the flat parts face each other. The pressure jig A may have a mechanism that adjusts the pressure applied to the metal particle film and the silicon substrate. As the pressure adjusting means, a spring or other means can be used.

The press can be carried out under the condition of, for example, a temperature of normal temperature to 50°C or lower, and may be carried out under the condition of the atmosphere in the vacuum, in the ambient atmosphere, or in the nitrogen. For the purpose of reducing voids, the metal particle film may be pressed against the silicon substrate after being held at a degree of vacuum of 1,000 Pa or less or a degree of vacuum of 200 Pa or less. The pressure of the pressure jig when pressing the metal particle film against the silicon substrate may be a pressure within a range in which the silicon wafer is not cracked, and may be, for example, 0.01 MPa or more, 0.1 MPa or more, or 1 MPa or more.

The metal paste part 3 may be sufficient to only cover at least the surface surrounding the hole of the substrate while the inside of the hole is filled, but as illustrated in FIGS. 2(b) and 2(c), the metal paste part may be pressed out from an opening portion (VP₀ in FIG. 2(a)) of the through-hole, the opening portion being positioned opposite to the side where the metal particle film of the substrate is pressed, to cover the surface around the hole.

[Step b]

In this step, the metal paste part is heated to remove a part of the volatile solvent. In other words, the metal paste part is heated so that a part of the volatile solvent remains. In a case where the above-described metal particle film is used, the metal paste part can be heated after the support film is peeled off.

The heating can be carried out, for example, by using a hot plate, a warm air dryer, a warm air heating furnace, a nitrogen dryer, an infrared dryer, an infrared heating furnace, a far infrared heating furnace, a microwave heating device, a laser heating device, an electromagnetic heating device, a heater heating device, a steam heating furnace, a hot plate press device, or other means.

The atmosphere for heating may be the ambient atmosphere, may be an oxygen-free atmosphere such as nitrogen and a rare gas, or may be a reducing atmosphere such as hydrogen and formic acid. For the ambient atmosphere, in a case where the heating temperature is higher than 100°C, the copper particles are easily oxidized, but in a case where the metal paste part contains the above-described high vapor pressure solvent as a volatile solvent, a part of the volatile solvent can be removed at a temperature of lower than 100°C, 95°C or lower, or 90°C or lower. In a case where the metal paste part does not contain the high vapor pressure solvent as a volatile solvent, for example, contains the above-described low vapor pressure solvent alone, the oxidation of the copper particles can be suppressed while a part of the volatile solvent is removed by heating at 110°C or higher, 130°C or higher, or 150°C or higher in an oxygen-free atmosphere or a reducing atmosphere.

In a case where the metal paste part contains the high vapor pressure solvent, the heating temperature may be 70°C or higher and lower than 100°C or may be 80°C or higher and 95°C or lower from the viewpoint of inhibiting the oxidation of the copper particles, and the heating time may be 5 to 60 minutes or 10 to 30 minutes from the viewpoint of inhibiting the oxidation of the copper particles.

In addition, the heating may be carried out so that the concentration of the metal particles in the metal paste part is 96% by mass or more, 97.5% by mass or more, or 98% by mass or more, from the viewpoint of reducing volume shrinkage before and after firing the conductive via precursor (for example, between step c of forming the conductive via precursor and step d of firing the conductive via precursor) to minimize voids and cracks.

### [Step c]

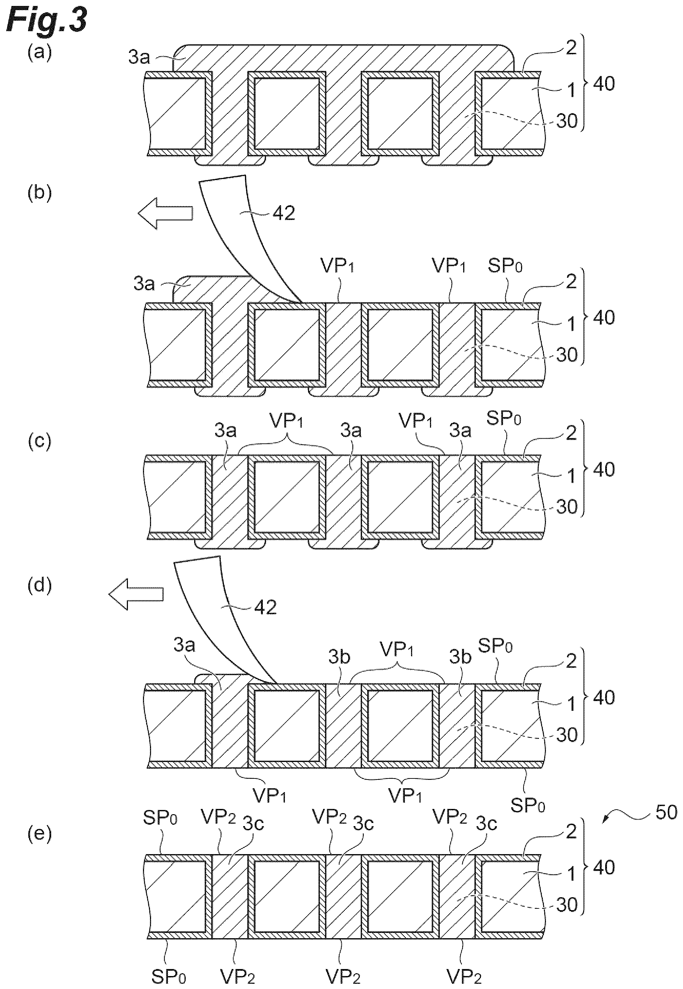

In this step, as illustrated in FIGS. 3(a) to 3(d), the metal paste with which the holes are filled is planarized (or smoothed) while the metal paste that covers the surface of the substrate is removed with respect to the metal paste part 3a that is obtained after heating in step b. As a result, conductive via precursors 3b, each has a planarized exposed surface VP₁ and contains the metal particles and the residue of the volatile solvent, can be formed inside holes (through-holes 30) (FIG. 3(d)).

The metal paste part can be removed, for example, by using a rubber squeegee 42 as illustrated in FIGS. 3(b) and 3(d). As a result, a part of the metal paste part (the metal paste covering the surface of the substrate and the metal paste protruding from the holes) can be removed such that a surface SP₀ of the substrate 40 and the exposed surface VP₁ of the conductive via precursor 3b are leveled to form a planarized plane. In addition, as another method, removal with a metal squeegee such as SUS can be mentioned.

The step height between the surface SP₀ of the substrate 40 and the exposed surface VP₁ of the conductive via precursor 3b may be 5 µm or less or 3 µm or less in a direction perpendicular to the substrate surface. In addition, the average step height calculated by the following method may fall within the above-described range.

### (Average Step Height)

An average step height is calculated by acquiring an image of a cross-section passing through the center of a hole (via), binarizing the cross-section image to obtain a cross-sectional area Sa surrounded by inner walls of the hole (via), an exposed surface of a conductive via precursor, and an opening surface of the hole (via), and dividing the cross-sectional area Sa by a distance Wa between the inner walls of the hole.

### [Step d]

In this step, the conductive via precursor 3b formed in step c is fired. Accordingly, a conductive via 3c including a metal body can be formed. The metal body can contain a copper sintered body having a porous structure, a solder present in the copper sintered body in an interspersed manner, and pores.

The firing can be performed by a heat treatment. The heat treatment can be carried out, for example, by using heating means such as a hot plate, a warm air dryer, a warm air heating furnace, a nitrogen dryer, an infrared dryer, an infrared heating furnace, a far infrared heating furnace, a microwave heating device, a laser heating device, an electromagnetic heating device, a heater heating device, and a steam heating furnace.

The atmosphere during the firing may be an oxygen-free atmosphere from the viewpoint of inhibiting the oxidation of the copper sintered body, or may be a reducing atmosphere from the viewpoint of removing the surface oxide of the copper particles in the conductive via precursor. Examples of the oxygen-free atmosphere include introduction of an oxygen-free gas such as nitrogen or a rare gas, or under a vacuum. Examples of the reducing atmosphere include pure hydrogen gas, a mixed gas of hydrogen and nitrogen represented by forming gas, nitrogen containing formic acid gas, a mixed gas of hydrogen and rare gas, and a rare gas containing formic acid gas. In a case where the conductive via precursor is sintered by heating without pressurization, the atmosphere may be pure hydrogen gas or a mixed gas of hydrogen and nitrogen represented by forming gas, and is preferably pure hydrogen gas. The heating in pure hydrogen gas can lead to a decrease in the sintering temperature of the copper particles. In a case where pure hydrogen gas is used, the gas reaches the center portion of the through-hole 30 even though the thickness of the substrate is as large as 600 µm, and the diameter of the through-hole 30 is as small as 10 µm. Thus, it is easy to obtain a metal body containing a copper sintered body.

The maximum attainable temperature during the heat treatment may be 150°C or higher, and may be 350°C or lower, 300°C or lower, or 260°C or lower from the viewpoint of reducing thermal damage to each member and improving the yield. As long as the maximum attainable temperature is 150°C or higher, sintering is likely to proceed sufficiently within a holding time of 60 minutes or less at the maximum attainable temperature. The holding time at the maximum attainable temperature may be 1 minute or more, and may be 60 minutes or less, 40 minutes or less, or 30 minutes or less from the viewpoint of volatilizing the entire volatile solvent and improving the yield.

The firing of the conductive via precursor may be performed without pressurization, or may be performed with a pressure applied. In the latter case, under a pure hydrogen gas-containing atmosphere, the pressure may be 0.05 MPa or more, 0.1 MPa or more, or 0.3 MPa or more, and may be 20 MPa or less, 15 MPa or less, or 10 MPa or less. In addition, under a nitrogen gas-containing atmosphere, the pressure may be 1 MPa or more, or 3 MPa or more, and may be 20 MPa or less, 15 MPa or less, or 10 MPa or less.

By setting the pressure to 0.05 MPa or more when pure hydrogen gas is used, and to 1 MPa or more when nitrogen gas is used, the occurrence of voids in the conductive via formed in the center portion of the through-hole 30 is easily minimized, and a conductive via having good conductivity is easily obtained. In addition, in a case where the silicon substrate 40 includes the metal coating 2, the bonding strength between the metal coating 2 and the conductive via is easily improved by setting the pressure to the above-described lower limit value or more.

In addition, in a case where the pressure applied during the firing is within the above-described range, a special pressurizing device is unnecessary. Thus, the minimization of voids, and a more improvement on the bonding strength and connection reliability can be achieved without impairing the yield. Examples of a method for applying pressure to the silicon substrate including the conductive via precursor that is formed in the through-hole include a method for placing a weight, a method for applying pressure using a pressurizing device, and a method for applying pressure using a fixing jig for applying pressure.

The ratio of the copper element among the constituent elements, excluding the light element, in the copper sintered body contained in the metal body may be 95% by mass or more, 97% by mass or more, 98% by mass or more, or 100% by mass. In a case where the ratio of the copper element in the copper sintered body is within the above-described range, it is possible to reduce the formation of an intermetallic compound or the precipitation of foreign elements on the grain boundaries of metal copper crystal, the properties of the metal copper constituting the copper sintered body are easily enhanced, and a more excellent connection reliability is easily obtained.

In step d, since the conductive via precursor has the exposed surface VP₁ that is planarized and has a sufficiently small step height with respect to the substrate surface, and further has a composition that contributes to a reduced occurrence of volume shrinkage caused by firing, the step height between the surface SP₀ of the substrate 40 and an exposed surface VP₂ of the conductive via 3c can be sufficiently reduced.

The step height between the surface SP₀ of the substrate 40 and the exposed surface VP₂ of the conductive via precursor 3c (or a recess of the conductive via 3c) may be 5 µm or less or 3 µm or less in a direction perpendicular to the substrate surface. In addition, the average step height calculated by the following method may fall within the above-described range.

### (Average Step Height)

An average step height is calculated by acquiring an image of a cross-section passing through the center of a hole (via), binarizing the cross-section image to obtain a cross-sectional area Sb surrounded by inner walls of the hole (via), an exposed surface of a conductive via, and an opening surface of the hole (via), and dividing the cross-sectional area Sb by a distance Wb between the inner walls of the hole.

A conductive via-containing substrate 50 can be obtained through the above-described steps a to d. In the conductive via-containing substrate 50, since the exposed surface of the conductive via is planarized (or smoothed), and the step height with respect to the surface SP₀ of the substrate 40 is sufficiently small, it is possible to form a wiring easily, and to exhibit a sufficiently low connection resistance value even after the wiring is formed.

The method for manufacturing a conductive via-containing substrate according to the present embodiment can further include step e of forming a wiring. This case can be used as a method for manufacturing a conductive via-containing wiring board.

### [Step e]

This step can include a resist forming step, a plating step, a resist removing step, and an etching step described below.

### <Resist Formation Step>

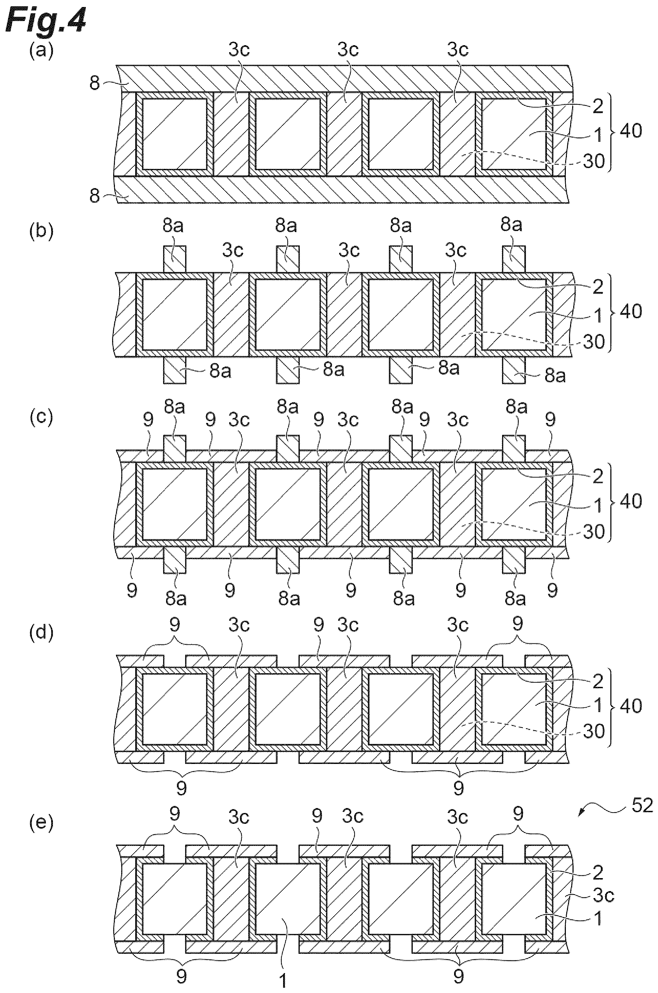

In the resist forming step, for example, as illustrated in FIGS. 4(a) and 4(b), an etching resist 8a can be formed in the following manner: a negative photosensitive dry film 8 for an etching resist is laminated on the main surface of the silicon substrate 40 and the conductive via 3c; a photomask that transmits light is then superimposed on a wiring shape; exposure is carried out with ultraviolet rays; and unexposed portions are removed with a developer.

Examples of a method for forming the etching resist 8a other than the above-described manner include methods of silk-screen printing a resist ink and bonding a dry film resist with a laminator.

### <Plating Step>

In the plating step, for example, as illustrated in FIG. 4(c), a wiring 9 can be formed on opening portions of the etching resist 8a by a method such as electrolytic plating or electroless plating.

### <Resist Removing Step>

In the resist removing step, for example, as illustrated in FIG. 4(d), the etching resist 8a can be removed by a method such as peeling by a wet process using an alkaline aqueous solution or an organic solvent-based chemical solution such as an organic amine-based chemical solution such as TMAH or a ketone-based chemical solution such as acetone, or peeling by a dry process such as plasma or ozone.

### <Etching Step>

In the etching step, the metal coating 2 at a portion without coverage of the wiring 9 can be removed by etching. In the present embodiment, a part of the metal coating 2 provided on both main surfaces of the silicon wafer 1 is removed by etching.

Examples of the etching method include methods using a chemical etching solution used for a normal wiring board, such as a solution containing cupric chloride and hydrochloric acid, a ferric chloride solution, a solution containing sulfuric acid and hydrogen peroxide, or an ammonium persulfate solution.

A conductive via-containing wiring board 52 as illustrated in FIG. 4(e) can be obtained through step e described above.

In the method described above, a step of removing at least a part of a conductor such as the sintered body of the metal paste or the metal coating 2, remaining on the main surface of the silicon substrate 40, may be provided before step e.

Examples of means for removing the conductor include chemical polishing, mechanical polishing, chemical mechanical polishing, fly cut treatment, plasma treatment, and other means. The fly cut process means cutting planarization by a surface planer.

According to the method for manufacturing a conductive via-containing substrate of the present embodiment, since it is possible to obtain a conductive via-containing substrate including a main surface (such as the metal coating 2, for example) that is sufficiently exposed, and having a conductive via that has a sufficiently small step height with respect to the main surface of the substrate, a step of planarizing the main surface of the substrate such as the step of removing the conductor described above can be omitted.

### [Examples]

Hereinafter, the present invention will be described in more details with reference to Examples and Comparative Examples, but the present invention is not limited to these Examples.

### <Preparation of Metal Paste>

### (Preparation Examples 1 to 26)

The following raw materials were mixed at the ratio illustrated in Tables 1 to 4 to prepare metal pastes.

### <First Copper Particles>

### (Wet Copper Powder)

Spherical copper particles W1: 1050Y (manufactured by MITSUI MINING & SMELTING CO., LTD., trade name, average particle diameter (D50): 0.81 µm, spherical shape)
Spherical copper particles W2: 1100Y (manufactured by MITSUI MINING & SMELTING CO., LTD., trade name, average particle diameter (D50): 1.1 µm, spherical shape)
Spherical copper particles W3: 1200Y (manufactured by MITSUI MINING & SMELTING CO., LTD., trade name, average particle diameter (D50): 2.1 µm, spherical shape)
Spherical copper particles W4: 1300Y (manufactured by MITSUI MINING & SMELTING CO., LTD., trade name, average particle diameter (D50): 3.5 µm, spherical shape)
Flat copper particles W1: 1100YP (manufactured by MITSUI MINING & SMELTING CO., LTD., trade name, average particle diameter (D50): 1.4 µm, flat)
Flat copper particles W2: 1200YP (manufactured by MITSUI MINING & SMELTING CO., LTD., trade name, average particle diameter (D50): 3.1 µm, flat)

### (Atomized Copper Powder)

Spherical copper particles A1: MA-C02K (manufactured by MITSUI MINING & SMELTING CO., LTD., trade name, average particle diameter (D50): 1.8 µm, spherical shape)
Spherical copper particles A2: MA-C025K (manufactured by MITSUI MINING & SMELTING CO., LTD., trade name, average particle diameter (D50): 2.4 µm, spherical shape)
Spherical copper particles A3: MA-C03K (manufactured by MITSUI MINING & SMELTING CO., LTD., trade name, average particle diameter (D50): 3.4 µm, spherical shape)

### <Second Copper Particles>

Spherical copper particles W5: CH0200L1 (manufactured by MITSUI MINING & SMELTING CO., LTD., trade name, average particle diameter (D50): 200 nm, spherical shape)

### <Solder Particles>

Solder particles 1: SnBi58 solder STC-3 (manufactured by MITSUI MINING & SMELTING CO., LTD., trade name, average particle diameter (D50): 4.1 µm, spherical shape)

### <Volatile Solvent>

(High vapor pressure solvent: vapor pressure of 4 Pa or more and 30 Pa or less at 20°C)
α-Terpineol: manufactured by FUJIFILM Wako Pure Chemical Corporation, vapor pressure of 6.5 Pa at 20°C
1,3-Butanediol: manufactured by SANKYO CHEMICAL CO.,LTD., vapor pressure of 8 Pa at 20°C
Ethyl carbitol: manufactured by Showa Chemical Industry Co., Ltd., vapor pressure of 13 Pa at 20°C
Propylene glycol diacetate: manufactured by Inoue Perfumery MFG. Co.,Ltd., vapor pressure of 30 Pa at 20°C
(Low vapor pressure solvent: vapor pressure of less than 4 Pa at 20°C)
Isobornyl cyclohexanol: manufactured by NIPPON TERPENE CHEMICALS, INC., product name: "Terusolve MTPH", vapor pressure of 0.004 Pa at 20°C
Dimethyl phthalate: manufactured by Showa Chemical Industry Co., Ltd., vapor pressure of 0.2 Pa at 20°C
Diethylene glycol mono-n-butyl ether: manufactured by Showa Chemical Industry Co., Ltd., vapor pressure of 1.3 Pa at 20°C

For the metal pastes obtained in Preparation Examples 1 to 26, the viscosity, printability, bondability, and volume resistivity were evaluated according to the following methods.

### <Viscosity>

The viscosity of the metal pastes was measured by using a micro spiral viscometer PCU-02V (manufactured by Malcom Co., Ltd., product name). The measurement conditions were a rotation speed of 10rpm and a temperature of 25°C.

### <Printability>

In <Production of Metal Particle Film> described later, when printing was carried out on a PET film having a thickness of 100 µm by a screen printer, the number of pinhole portions where the coating was not applied on the PET film was measured. The printability was evaluated based on the number of pinhole portions according to the following criteria. Those evaluated as A to D can be determined to be good.

### (Criteria)

A: The number of pinhole portions is 0.
B: The number of pinhole portions is 1 or more and less than 3.
C: The number of pinhole portions is 3 or more and less than 5.
D: The number of pinhole portions is 5 or more and less than 10.
E: The number of pinhole portions is 10 or more and less than 20.
F: The number of pinhole portions is 20 or more.

In addition, in <Production of Metal Particle Film> described later, after the printing was carried out on the PET film having a thickness of 100 µm by the screen printer, the coating amount (g) at a size of 8-inch φ was measured.

### <Bondability>

According to the following method, a bonding sample for a shear strength test was produced, and a die shear strength was measured to evaluate the bondability according to the following criteria. Those evaluated as A to C can be determined to be good.

### (Production of Bonding Sample for Shear Strength Test)

A metal paste was stencil-printed on a copper plate having a size of 25 × 20 × a thickness of 3 mm using a stainless steel mask having a square opening of 3 × 3 mm² and a thickness of 100 µm, and a squeegee. After drying at 90°C for 10 minutes with a hot plate, the resulting product was placed in a tube furnace (manufactured by AVC Co., LTD.), and argon gas flowed at a flow rate of 1 L/min to replace air in the tube furnace with argon gas. Thereafter, the temperature was increased to 225°C for 10 minutes while hydrogen gas flowed at 300 mL/min, and a sintering treatment was carried out at 225°C for 60 minutes to sinter the metal paste. Thereafter, the resulting product was cooled while argon gas flowed at a flow rate of 0.3 L/min and taken out into air at 50°C or lower to obtain a substrate containing a metal body formed on a copper plate as a bonding sample for the shear strength test.

### (Measurement of Die Shear Strength)

For the bonding sample for a shear strength test, the die shear strength was measured with a universal bond tester (4000 series, manufactured by Dage Japan Co., Ltd.) equipped with a DS-100 load cell by pressing the metal body or the Cu plate in the horizontal direction under the measurement conditions of a measurement speed of 5 mm/min and a measurement height of 50 µm. The mean value of 10 points was calculated and used as the mean value of the bonding strength.

### (Criteria)

A: Mean value of bonding strength is 50 N or more.
B: Mean value of bonding strength is 40 N or more and less than 50 N.
C: Mean value of bonding strength is 20 N or more and less than 40 N.
D: Mean value of bonding strength is 10 N or more and less than 20 N.
E: Mean value of bonding strength is less than 10 N.

### <Measurement of Volume Resistivity>

The metal paste prepared as described above was applied onto a glass wafer having a thickness of 1 mm by using an automatic film applicator (manufactured by Allgood Corporation, product name) such that the application thickness was about 150 µm. The coating area was about 5 cm × about 10 cm. After the wafer provided with the coating film was dried at 90°C for 10 minutes with a hot plate, the resulting wafer was placed in a tube furnace (manufactured by AVC Co., LTD.), and argon gas flowed at a flow rate of 1 L/min to replace air in the tube furnace with argon gas. Thereafter, the temperature was increased to 225°C for 10 minutes while hydrogen gas flowed at 300 mL/min, and a sintering treatment was carried out at 225°C for 60 minutes to sinter the metal paste. Thereafter, the resulting wafer was cooled while argon gas flowed at a flow rate of 0.3 L/min and taken out into air at 50°C or lower to obtain a sample with a metal body formed on the wafer.

The volume resistivity of the metal body in the above-described sample was calculated from the surface resistance value measured with a four-point probe resistivity meter (manufactured by Mitsubishi Chemical Analytech Co., Ltd., trade name: Loresta GP) and the film thickness obtained with a non-contact surface/layer cross-sectional shape measurement system (VertScan, Ryoka Systems Inc.).

**[Table 1]**

| | | | | | Preparation Example 1 | Preparation Example 2 | Preparation Example 3 | Preparation Example 4 | Preparation Example 5 | Preparation Example 6 | Preparation Example 7 | Preparation Example 8 | Preparation Example 9 |
|---|---|---|---|---|---|---|---|---|---|---|---|---|---|
| | | | Wet copper powder | Spherical copper particles W1 | 30 | 45 | - | - | - | - | - | - | - |
| | | | | Spherical copper particles W2 | - | - | - | 30 | 45 | - | - | - | - |
| | | | | Spherical copper particles W3 | - | - | - | - | - | - | 30 | 45 | - |
| | | First copper particles | | Spherical copper particles W4 | - | - | - | - | - | - | - | - | - |
| | Copper particles | | | Flat copper particles W1 | - | - | - | - | - | - | - | - | - |
| | | | | Flat copper particles W2 | - | - | - | - | - | - | - | - | - |
| | | | Atomized copper powder | Spherical copper particles A1 | 30 | - | 45 | - | - | - | - | - | - |
| | | | | Spherical copper particles A2 | - | - | - | 30 | - | 45 | - | - | - |
| | | | | Spherical copper particles A3 | - | - | - | - | - | - | 30 | - | 45 |
| Composition | | Second copper particles | Wet copper powder | Spherical copper particles W5 | 30 | 45 | 45 | 30 | 45 | 45 | 30 | 45 | 45 |
| | Solder particles | Solder particles 1 | | | 5 | 5 | 5 | 5 | 5 | 5 | 5 | 5 | 5 |
| | Volatile solvent | High vapor pressure solvent | α-Terpineol (6.5 Pa) | | 2.5 | 2.5 | 2.5 | 2.5 | 2.5 | 2.5 | 2.5 | 2.5 | 2.5 |
| | | | 1,3-Butanediol (8 Pa) | | - | - | - | - | - | - | - | - | - |
| | | | Ethyl carbitol (13 Pa) | | - | - | - | - | - | - | - | - | - |
| | | | Propylene glycol diacetate (30 Pa) | | - | - | - | - | - | - | - | - | - |
| | | Low vapor pressure solvent | Isobornyl cyclohexanol | | 2.5 | 2.5 | 2.5 | 2.5 | 2.5 | 2.5 | 2.5 | 2.5 | 2.5 |
| | | | Dimethyl phthalate | | - | - | - | - | - | - | - | - | - |
| | | | Diethylene glycol mono-n-butyl ether | | - | - | - | - | - | - | - | - | - |
| Properties | Viscosity (Pa·s at 25°C) | | | | 300 | 368 | 280 | 290 | 353 | 265 | 280 | 335 | 240 |
| | Printability | Criteria | | | A | B | B | A | B | A | A | B | A |
| | | Coating amount (g) | | | 4.8 | 5.4 | 3.7 | 3.7 | 5.4 | 3.9 | 3.4 | 5.1 | 3.7 |
| | Bondability | Bonding strength with Cu (N) | | | 65 | 57 | 42 | 63 | 54 | 45 | 65 | 48 | 41 |
| | | Criteria | | | A | A | B | A | A | B | A | A | B |
| | Volume resistivity (µΩ·cm) | | | | 4.9 | 4.3 | 7.2 | 5.1 | 4.6 | 5.3 | 7.7 | 4.7 | 8.8 |

**[Table 2]**

| | | | | | Preparation Example 10 | Preparation Example 11 | Preparation Example 12 | Preparation Example 13 | Preparation Example 14 | Preparation Example 15 | Preparation Example 16 | Preparation Example 17 |
|---|---|---|---|---|---|---|---|---|---|---|---|---|
| | | | Wet copper powder | Spherical copper particles W1 | - | - | - | - | 20 | - | 30 | 30 |
| | | | | Spherical copper particles W2 | - | | - | | - | - | - | - |
| | | | | Spherical copper particles W3 | - | - | - | - | 20 | - | - | - |
| | | First copper particles | | Spherical copper particles W4 | - | - | - | - | 20 | - | - | - |
| | Copper particles | | | Flat copper particles W1 | 30 | 45 | - | - | - | - | - | - |
| | | | | Flat copper particles W2 | - | - | 30 | 45 | - | - | - | - |
| | | | Atomized copper powder | Spherical copper particles A1 | | - | - | - | - | 20 | 30 | 30 |
| | | | | Spherical copper particles A2 | 30 | - | - | - | - | 20 | - | - |
| | | | | Spherical copper particles A3 | - | - | 30 | - | - | 20 | - | - |
| Composition | | Second copper particles | Wet copper powder | Spherical copper particles W5 | 30 | 45 | 30 | 45 | 30 | 30 | 30 | 30 |
| | Solder particles | Solder particles 1 | | | 5 | 5 | 5 | 5 | 5 | 5 | 5 | 5 |
| | Volatile solvent | High vapor pressure solvent | α-Terpineol (6.5 Pa) | | 2.5 | 2.5 | 2.5 | 2.5 | 2.5 | 2.5 | 5 | 4 |
| | | | 1,3-Butanediol (8 Pa) | | - | - | - | - | - | - | - | - |
| | | | Ethyl carbitol (13 Pa) | | - | - | - | - | - | - | - | - |
| | | | Propylene glycol diacetate (30 Pa) | | - | - | - | - | - | - | - | - |
| | | Low vapor pressure solvent | Isobornyl cyclohexanol | | 2.5 | 2.5 | 2.5 | 2.5 | 2.5 | 2.5 | 0 | 1 |
| | | | Dimethyl phthalate | | - | - | - | - | - | - | - | - |
| | | | Diethylene glycol mono-n-butyl ether | | - | - | - | - | - | - | - | - |
| Properties | Viscosity (Pa·s at 25°C) | | | | 421 | 520 | 385 | 487 | 452 | 198 | 286 | 295 |
| | Printability | Criteria | | | C | D | C | D | C | A | A | A |
| | | Coating amount (g) | | | 6.7 | 9.5 | 8.9 | 10.5 | 7.0 | 5.1 | 4.2 | 4.3 |
| | Bondability | Bonding strength with Cu (N) | | | 58 | 42 | 56 | 41 | 60 | 30 | 65 | 63 |
| | | Criteria | | | A | B | A | B | A | C | A | A |
| | Volume resistivity (µΩ·cm) | | | | 5.3 | 9.3 | 5.4 | 9.5 | 10.2 | 12.3 | 4.8 | 5.2 |

**[Table 3]**

| | | | | | Preparation Example 18 | Preparation Example 19 | Preparation Example 20 | Preparation Example 21 | Preparation Example 22 | Preparation Example 23 | Preparation Example 24 |
|---|---|---|---|---|---|---|---|---|---|---|---|
| | | | Wet copper powder | Spherical copper particles W1 | 30 | 30 | 30 | 30 | 30 | 30 | 30 |
| | | | | Spherical copper particles W2 | - | - | - | - | - | - | - |
| | | | | Spherical copper particles W3 | - | - | - | - | - | - | - |
| | | First copper particles | | Spherical copper particles W4 | - | - | - | - | - | - | - |
| | Copper particles | | | Flat copper particles W1 | - | - | - | - | - | - | - |
| | | | | Flat copper particles W2 | - | - | - | - | - | - | - |
| | | | Atomized copper powder | Spherical copper particles A1 | 30 | 30 | 30 | 30 | 30 | 30 | 30 |
| | | | | Spherical copper particles A2 | - | - | - | - | - | - | - |
| | | | | Spherical copper particles A3 | - | - | - | - | - | - | - |
| Composition | | Second copper particles | Wet copper powder | Spherical copper particles W5 | 30 | 30 | 30 | 30 | 30 | 30 | 30 |
| | Solder particles | Solder particles 1 | | | 5 | 5 | 5 | 5 | 5 | 5 | 5 |
| | Volatile solvent | High vapor pressure solvent | α-Terpineol (6.5 Pa) | | 1 | 0 | - | - | - | - | - |
| | | | 1,3-Butanediol (8 Pa) | | - | - | 2.5 | - | - | 2.5 | 2.5 |
| | | | Ethyl carbitol (13 Pa) | | - | - | - | 2.5 | - | - | - |
| | | | Propylene glycol diacetate (30 Pa) | | - | - | - | - | 2.5 | - | - |
| | | Low vapor pressure solvent | Isobornyl cyclohexanol | | 4 | 5 | 2.5 | 2.5 | 2.5 | - | - |
| | | | Dimethyl phthalate | | - | - | - | - | - | 2.5 | - |
| | | | Diethylene glycol mono-n-butyl ether | | - | - | - | - | - | - | 2.5 |
| Properties | Viscosity (Pa·s at 25°C) | | | | 520 | 670 | 310 | 290 | 274 | 120 | 100 |
| | Printability | Criteria | | | D | D | A | A | A | A | A |
| | | Coating amount (g) | | | 4.4 | 4.8 | 5.5 | 4.7 | 4.5 | 4.2 | 4.1 |
| | Bondability | Bonding strength with Cu (N) | | | 27 | 32 | 65 | 65 | 65 | 74 | 84 |
| | | Criteria | | | C | C | A | A | A | A | A |
| | Volume resistivity (µΩ·cm) | | | | 5.5 | 6.8 | 4.7 | 4.7 | 4.9 | 4.4 | 3.4 |

**[Table 4]**

| | | | | | Preparation Example 25 | Preparation Example 26 |
|---|---|---|---|---|---|---|
| | | | Wet copper powder | Spherical copper particles W1 | - | - |
| | | | | Spherical copper particles W2 | - | - |
| | | | | Spherical copper particles W3 | - | - |
| | Copper particles | First copper particles | | Spherical copper particles W4 | - | - |
| | | | | Flat copper particles W1 | - | 25 |
| | | | | Flat copper particles W2 | - | - |
| | | | Atomized copper powder | Spherical copper particles A1 | - | - |
| | | | | Spherical copper particles A2 | - | - |
| | | | | Spherical copper particles A3 | - | - |
| Composition | | Second copper particles | Wet copper powder | Spherical copper particles W5 | 92 | 70 |
| | Solder particles | Solder particles 1 | | | - | - |
| | Volatile solvent | High vapor pressure solvent | α-Terpineol (6.5 Pa) | | 4 | 2.5 |
| | | | 1,3-Butanediol (8 Pa) | | - | - |
| | | | Ethyl carbitol (13 Pa) | | - | - |
| | | | Propylene glycol diacetate (30 Pa) | | - | - |
| | | Low vapor pressure solvent | Isobornyl cyclohexanol | | 4 | 2.5 |
| | | | Dimethyl phthalate | | - | - |
| | | | Diethylene glycol mono-n-butyl ether | | - | - |
| Properties | Viscosity (Pa·s at 25°C) | | | | 550 | 540 |
| | Printability | Criteria | | | E | D |
| | | Coating amount (g) | | | 13.2 | 13.1 |
| | Bondability | Bonding strength with Cu (N) | | | 5 | 23 |
| | | Criteria | | | F | C |
| | Volume resistivity (µΩ·cm) | | | | 4.2 | 5.2 |

### [Production of Conductive Via-Containing Silicon Substrate]

### (Examples 1 to 24 and Comparative Examples 1 and 2)

A conductive via-containing silicon substrate was produced by the following procedure.

### <Preparation of Silicon Substrate>

A silicon substrate provided with through-holes and including a titanium layer, a nickel layer, and a copper layer, which are layered in this order on both main surfaces and on wall surfaces of the through-holes, was prepared. The silicon substrate has a diameter of 6 inches and a thickness of 300 µm, the titanium layer, the nickel layer, and the copper layer are sequentially formed by sputtering, and each through-hole has a hole diameter (via diameter) of 30 µm.

### <Production of Metal Particle Film>

The metal paste prepared as described above was printed on a PET film having a thickness of 100 µm with a screen printer in a size of 8-inch φ (circular shape with a diameter of 20 cm) using a screen printing plate (wire diameter: 23 µm, the number of meshes: 400, mesh size: 41 µm, and space ratio: 41 µm) to obtain a metal particle film provided with a metal particle-containing layer.

### <Formation of Conductive Via>

The metal particle film was bonded to the silicon substrate from the metal particle-containing layer side with a bonding device VJ-35 (manufactured by Ayumi Industry Co., Ltd., product name), and the resulting laminate was further pressed at room temperature in the ambient atmosphere at a pressure of 3 MPa to fill the through-holes with the metal paste. At this time, the metal paste was protruded from one side of the silicon substrate opposite to the other side of the silicon substrate on which the metal particle film was bonded.

Subsequently, the PET film peeled off from the laminate was dried in the ambient atmosphere at 90°C for 10 minutes. Examples 18 and 19 were dried alone at 130°C for 60 minutes in a nitrogen atmosphere (flow rate of 5 L/min). The drying was carried out under the condition in which the concentration of the metal particles in the metal paste changed as follows.
Examples 1 to 15 and 20 to 22: 95% by mass→97.5% by mass
Example 16: 95% by mass→99.5% by mass
Example 17: 95% by mass→99% by mass
Example 18: 95% by mass→98.4% by mass
Example 19: 95% by mass→97.6% by mass
Example 23: 95% by mass→98.2% by mass
Example 24: 95% by mass→98.5% by mass
Comparative Example 1: 92% by mass→96% by mass
Comparative Example 2: 95% by mass→97.5% by mass

For the dried laminate, as illustrated in FIGS. 3(a) to 3(d), the metal paste on the main surface of the silicon substrate on which the metal particle film was bonded was removed using a rubber squeegee, and subsequently, the metal paste protruding from one side of the silicon substrate opposite to the other side of the silicon substrate on which the metal particle film was bonded was removed using the rubber squeegee.

Subsequently, the silicon substrate having conductive via precursors formed in the through-holes by the above-described steps was placed in a tube furnace (manufactured by AVC Co., LTD.), and argon gas flowed at a flow rate of 1 L/min to replace air in the tube furnace with argon gas. Thereafter, the temperature was increased to 225°C for 10 minutes while hydrogen gas flowed at 300 mL/min, and a sintering treatment was carried out at 225°C for 60 minutes to sinter the conductive via precursors. Thereafter, the resulting substrate was cooled while argon gas flowed at a flow rate of 0.3 L/min and taken out into air at 50°C or lower to obtain a conductive via-containing silicon substrate.

### [Evaluation on Conductive Via-Containing Silicon Substrate]

For the conductive via-containing silicon substrate obtained as described above, the presence or absence of cracks and voids in the conductive vias and the recess after sintering was evaluated according to the following method.

### (Presence or Absence of Cracks in Conductive Vias)

The cross-section of the conductive vias of the conductive via-containing silicon substrate was exposed by cross-section polishing, and 30 conductive vias were observed with a digital microscope (manufactured by KEYENCE CORPORATION, trade name: VHX-6000) to confirm the presence or absence of cracks (a length of 10 µm or more).

### (Presence or Absence of Voids in Conductive Vias)

The cross-section of the conductive vias of the conductive via-containing silicon substrate was exposed by cross-section polishing, and 30 conductive vias were observed with a digital microscope (manufactured by KEYENCE CORPORATION, trade name: VHX-6000) to confirm the presence or absence of voids (a diameter of 5 µm or more).

### (Recess after Sintering)

The cross-section of the conductive vias of the conductive via-containing silicon substrate was exposed by cross-section polishing, and 30 conductive vias were observed with a digital microscope (manufactured by KEYENCE CORPORATION, trade name: VHX-6000) to calculate the average step height by the following method.

### [Average Step Height]

An average step height (= Sb/Wb) was calculated by acquiring an image of a cross-section passing through the center of a via, binarizing the cross-section image to obtain a cross-sectional area Sb surrounded by inner walls of the via, an exposed surface of a conductive via, and an opening surface of the via, and dividing the cross-sectional area Sb by a distance Wb between the inner walls of the hole.

The mean value of the average step heights at 30 points was calculated, and the recess after sintering was evaluated according to the following criteria. Those evaluated as A, B, and C can be determined to be good.

### (Criteria)

A: Mean value of average step heights is less than 1 µm.
B: Mean value of average step heights is 1 µm or more and less than 3 µm.
C: Mean value of average step heights is 3 µm or more and less than 5 µm.
D: Mean value of average step heights is 5 µm or more and less than 10 µm.
E: Mean value of average step heights is 10 µm or more.

### <Evaluation on Wiring Board >

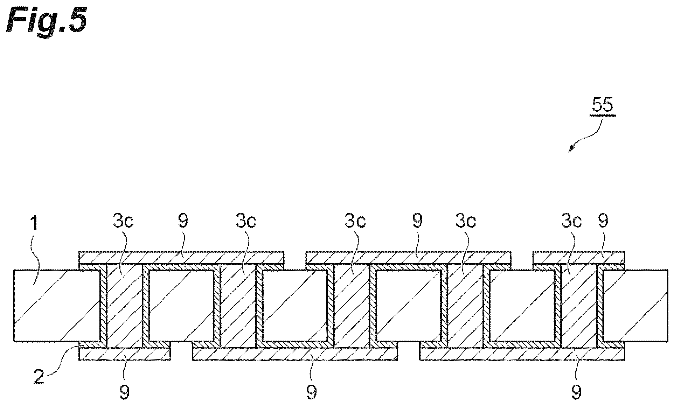

A dry film H-W425 (manufactured by Resonac Holdings Corporation, product name) for an ultraviolet curable etching resist was pressure-bonded to the surface of the conductive via-containing silicon substrate obtained as described above with a laminator. Thereafter, a photomask was aligned to expose a wiring pattern, and resist development was carried out. Next, electrolytic plating was carried out on opening portions of the resist, and peeling of the resist and etching of the seed layer were then carried out to form a wiring having a wiring pattern of 300 µm × 600 µm, thereby obtaining a test piece 55 (wiring board) as illustrated in FIG. 5. In the test piece 55, the conductive vias formed in the through-holes are electrically connected by the wiring provided on the substrate surface.

For the test piece obtained as described above, the initial resistance value, the connection reliability, the presence or absence of cracking in the substrate, and the recesses of the conductive vias after resist peeling were evaluated according to the following methods.

### (Initial Resistance Value)

As the initial resistance value of the test piece 55, a resistance value of 30 interconnected through-holes was measured. The initial resistance value was evaluated based on this interconnection resistance value according to the following criteria. Those evaluated as A and B can be determined to be good.

### (Criteria)

A: Resistance value is less than 10 mΩ.
B: Resistance value is 10 mΩ or more and less than 30 mΩ.
C: Resistance value is 30 mΩ or more and less than 100 mΩ.
D: Resistance value is 100 mΩ or more and less than 500 mΩ.
E: Resistance value is 500 mΩ or more.

### (Connection Reliability)

The test piece 55 was set in a temperature cycle tester (TSA-72SE-W, manufactured by ESPEC CORP.), and a temperature cycle connection reliability test was carried out under the conditions of low temperature side: -40°C, 15 minutes, room temperature: 2 minutes, high temperature side: 125°C, 15 minutes, defrosting cycle: automatic, and the number of cycles: 50, 100, 300, and 500 cycles. For the test piece 55 after undergoing each of the number of cycles, a resistance value of 30 interconnected through-holes was measured. The connection reliability was evaluated based on this interconnection resistance value according to the following criteria.

### (Criteria)

A: Resistance change rate is less than 1% with respect to initial resistance value.
B: Resistance change rate is 1% or more and less than 3% with respect to initial resistance value.
C: Resistance change rate is 3% or more and less than 5% with respect to initial resistance value.
D: Resistance change rate is 5% or more and less than 10% with respect to initial resistance value.
E: Resistance change rate is 10% or more and less than 20% with respect to initial resistance value.
F: Resistance change rate is 20% or more with respect to initial resistance value.

### (Cracking of Substrate)

The test piece 55 was visually confirmed, and the presence or absence of cracking of the silicon substrate was confirmed.

### (Recess after Resist Peeling)

As for the production of the test piece 55, after resist peeling, the cross-section of the conductive vias was exposed by cross-section polishing, and 30 conductive vias were observed with a digital microscope (manufactured by KEYENCE CORPORATION, trade name: VHX-6000) to calculate the mean value of the average step heights by the same method as for evaluating the recess after sintering. Then, the recess after resist peeling was evaluated according to the following criteria. Those evaluated as A, B, and C can be determined to be good.

### (Criteria)

A: Mean value of average step heights is less than 1 µm.
B: Mean value of average step heights is 1 µm or more and less than 3 µm.
C: Mean value of average step heights is 3 µm or more and less than 5 µm.
D: Mean value of average step heights is 5 µm or more and less than 10 µm.
E: Mean value of average step heights is 10 µm or more.

### [Observation and Consideration of Conductive Vias]

### (Observation 1)

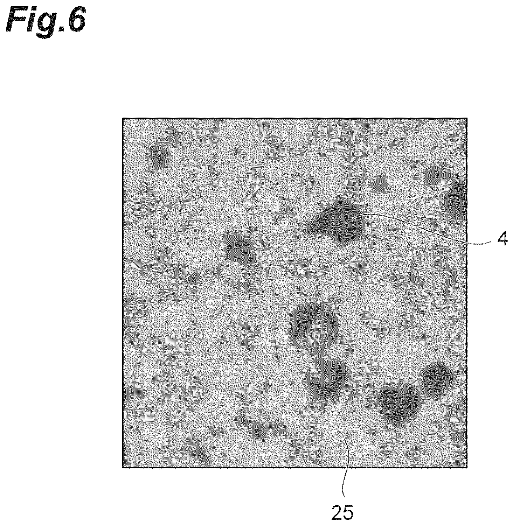

For the conductive via-containing silicon substrate produced in Example 1, the cross-section of the conductive vias was exposed by cross-section polishing, and the cross-section image was imaged with a digital microscope (manufactured by KEYENCE CORPORATION, trade name: VHX-6000) (see FIG. 6). As illustrated in FIG. 6, the conductive via includes the copper sintered body, the solder 25, and void spaces 4, and the void spaces exists in the copper sintered body, the inside of the solder, and the outer peripheral portion of the solder (between the solder and the copper sintered body).

### (Observation 2)

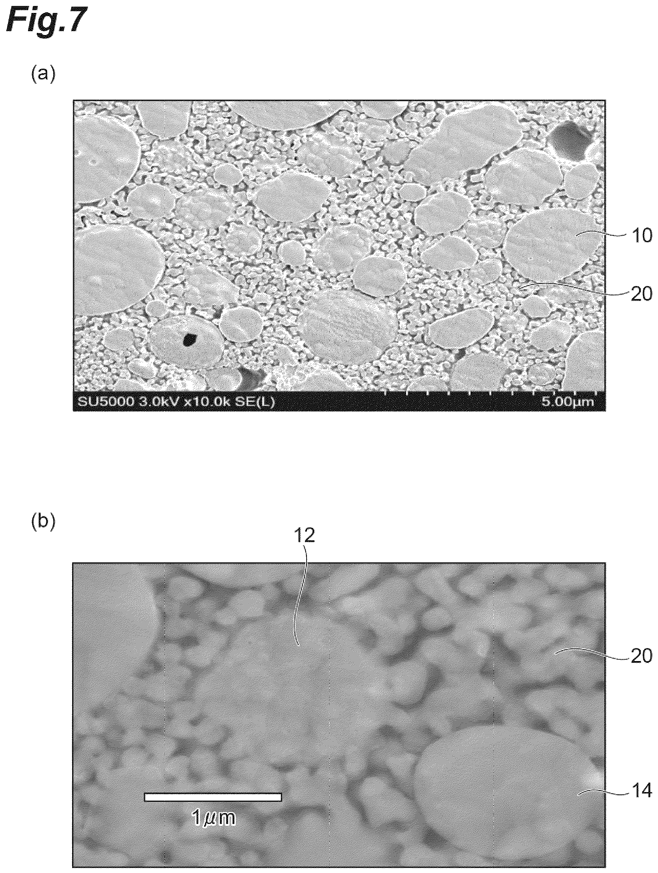

The cross-section of the center portion of the conductive via of the conductive via-containing silicon substrate was exposed using a focused ion beam machining observation device (manufactured by Hitachi High-Tech Corporation, product name: MI4050) by the focused ion beam, and the resulting cross-section was observed. For the observation, a cross-section image (about 10 µm square) of the copper sintered body was imaged using a scanning electron microscope (manufactured by Hitachi High-Tech Corporation, product name: S-3700N) at a magnification of 10,000 times (see FIG. 7). As illustrated in FIG. 7(a), the copper sintered body has the structure in which the second copper particles 20 are dispersed throughout, with the first copper particles 10 distributed among the second copper particles 20. In addition, as seen in the enlarged view of the cross-section image illustrated in FIG. 7(b), although the wet copper powder 12 of the first copper particles has the properties of being more easily bonded to the second copper particles than the atomized copper powder 14, it is possible to further improve the connection reliability by using the wet copper powder and the atomized copper powder in combination. It is considered that such an effect is due to the following reasons: since the wet copper powder 12 that is easily bonded to the second copper particles and the atomized copper powder 14 that has a wide particle size distribution coexisted, particles of the wet copper powder 12 were bonded to the second copper particles while bonding between particles of the atomized copper powder 14, and as a result, the formation of a strong sintered body based on the close-packed structure, and the reduction of shrinkage during sintering to minimize occurrence of voids and cracks and minimize the recesses have been highly achieved.

### (Observation 3)

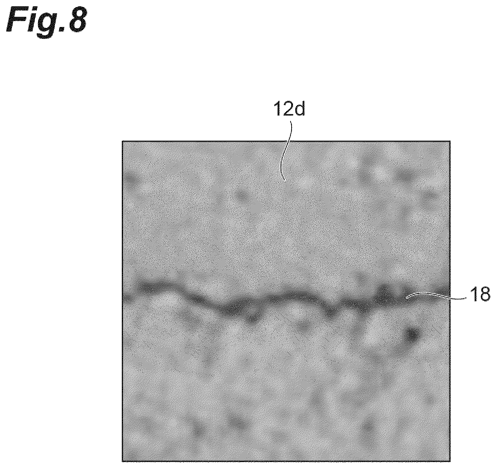

For the conductive via-containing silicon substrate produced in Comparative Example 2, the cross-section of the conductive vias was exposed by cross-section polishing, and the cross-section image (about 10 µm × 10 µm square) was imaged with a digital microscope (manufactured by KEYENCE CORPORATION, trade name: VHX-6000) (see FIG. 8). As illustrated in FIG. 8, a crack 18 was observed inside a copper sintered body 12d constituting the conductive via. In the conductive via-containing silicon substrate produced in Examples, it is considered that the occurrence of the above-described cracks is minimized by the solder that is derived from the solder particles and present in an interspersed manner.

**[Table 5]**

| | | | Example 1 | Example 2 | Example 3 | Example 4 | Example 5 | Example 6 | Example 7 | Example 8 | Example 9 |
|---|---|---|---|---|---|---|---|---|---|---|---|
| Metal paste | | | Preparation Example 1 | Preparation Example 2 | Preparation Example 3 | Preparation Example 4 | Preparation Example 5 | Preparation Example 6 | Preparation Example 7 | Preparation Example 8 | Preparation Example 9 |
| Substrate | | Material | Silicon | Silicon | Silicon | Silicon | Silicon | Silicon | Silicon | Silicon | Silicon |
| | | Hole type | Through-hole | Through-hole | Through-hole | Through-hole | Through-hole | Through-hole | Through-hole | Through-hole | Through-hole |
| | | Via diameter (µm) | 30 | 30 | 30 | 30 | 30 | 30 | 30 | 30 | 30 |
| | | Via depth (µm) | 300 | 300 | 300 | 300 | 300 | 300 | 300 | 300 | 300 |
| step a | | Filling method | Vacuum press | Vacuum press | Vacuum press | Vacuum press | Vacuum press | Vacuum press | Vacuum press | Vacuum press | Vacuum press |
| step b | | Temperature (°C) | 90 | 90 | 90 | 90 | 90 | 90 | 90 | 90 | 90 |
| | | Atmosphere Removing method | Ambient atmosphere Squeegee | Ambient atmosphere Squeegee | Ambient atmosphere Squeegee | Ambient atmosphere Squeegee | Ambient atmosphere Squeegee | Ambient atmosphere Squeegee | Ambient atmosphere Squeegee | Ambient atmosphere Squeegee | Ambient atmosphere Squeegee |
| step c | | | | | | | | | | | |
| step d | | Temperature (°C) | 220 | 220 | 220 | 220 | 220 | 220 | 220 | 220 | 220 |
| | | Atmosphere | 100% H₂ | 100% H₂ | 100% H₂ | 100% H₂ | 100% H₂ | 100% H₂ | 100% H₂ | 100% H₂ | 100% H₂ |
| Conductive via | Crack | | Absence | Absence | Absence | Absence | Absence | Absence | Absence | Absence | Absence |
| | Void | | Absence | Absence | Absence | Absence | Absence | Absence | Absence | Absence | Absence |
| | Recess after sintering | (µm) | 0.6 | 1.5 | 1.5 | 0.6 | 1.5 | 2.5 | 0.7 | 1.9 | 2.8 |
| | | Criteria | A | B | B | A | B | B | A | B | B |
| | Recess after resist peeling | (µm) | 0.8 | 1.8 | 1.9 | 0.8 | 2.3 | 2.8 | 0.9 | 2.9 | 3.6 |
| | | Criteria | A | B | B | A | B | B | A | B | C |
| Wiring board | Initial resistance value | | A | A | A | A | A | A | A | A | A |
| | After reliability test | 50 cycles | A | A | A | A | A | A | A | A | A |
| | | 100 cycles | A | A | A | A | A | A | A | A | A |
| | | 300 cycles | A | B | B | A | B | B | A | B | B |
| | | 500 cycles | A | B | B | A | B | B | A | B | B |
| | Cracking in substrate | | Absence | Absence | Absence | Absence | Absence | Absence | Absence | Absence | Absence |

**[Table 6]**

| | | | Example 10 | Example 11 | Example 12 | Example 13 | Example 14 | Example 15 | Example 16 | Example 17 |
|---|---|---|---|---|---|---|---|---|---|---|
| Metal paste | | | Preparation Example 10 | Preparation Example 11 | Preparation Example 12 | Preparation Example 13 | Preparation Example 14 | Preparation Example 15 | Preparation Example 16 | Preparation Example 17 |
| Substrate | | Material | Silicon | Silicon | Silicon | Silicon | Silicon | Silicon | Silicon | Silicon |
| | | Hole type | Through-hole | Through-hole | Through-hole | Through-hole | Through-hole | Through-hole | Through-hole | Through-hole |
| | | Via diameter (µm) | 30 | 30 | 30 | 30 | 30 | 30 | 30 | 30 |
| | | Via depth (µm) | 300 | 300 | 300 | 300 | 300 | 300 | 300 | 300 |
| step a | | Filling method | Vacuum press | Vacuum press | Vacuum press | Vacuum press | Vacuum press | Vacuum press | Vacuum press | Vacuum press |
| step b | | Temperature (°C) | 90 | 90 | 90 | 90 | 90 | 90 | 90 | 90 |
| | | Atmosphere Removing method | Ambient atmosphere Squeegee | Ambient atmosphere Squeegee | Ambient atmosphere Squeegee | Ambient atmosphere Squeegee | Ambient atmosphere Squeegee | Ambient atmosphere Squeegee | Ambient atmosphere Squeegee | Ambient atmosphere Squeegee |
| step c | | | | | | | | | | |
| step d | | Temperature (°C) | 220 | 220 | 220 | 220 | 220 | 220 | 220 | 220 |
| | | Atmosphere | 100% H₂ | 100% H₂ | 100% H₂ | 100% H₂ | 100% H₂ | 100% H₂ | 100% H₂ | 100% H₂ |
| Conductive via | Crack | | Absence | Absence | Absence | Absence | Absence | Absence | Absence | Absence |
| | Void | | Absence | Absence | Absence | Absence | Absence | Absence | Absence | Absence |
| | Recess after sintering | (µm) | 2.7 | 3.4 | 2.9 | 3.5 | 2.7 | 2.5 | 2.9 | 1.9 |
| | | Criteria | B | C | C | C | B | B | B | B |
| | Recess after resist peeling | (µm) | 3.4 | 3.9 | 3.9 | 4.5 | 3.9 | 3.2 | 4.3 | 3.2 |
| | | Criteria | C | C | C | C | C | C | C | C |
| Wiring board | Initial resistance value | | A | A | A | A | A | A | A | A |
| | After reliability test | 50 cycles | A | B | A | B | A | A | A | A |
| | | 100 cycles | A | B | A | B | B | B | A | A |
| | | 300 cycles | B | B | B | B | B | B | A | A |
| | | 500 cycles | C | C | C | C | B | B | B | A |
| | Cracking in substrate | | Absence | Absence | Absence | Absence | Absence | Absence | Absence | Absence |

**[Table 7]**

| | | | Example 18 | Example 19 | Example 20 | Example 21 | Example 22 | Example 23 | Example 24 |
|---|---|---|---|---|---|---|---|---|---|
| Metal paste | | | Preparation Example 18 | Preparation Example 19 | Preparation Example 20 | Preparation Example 21 | Preparation Example 22 | Preparation Example 23 | Preparation Example 24 |
| Substrate | | Material | Silicon | Silicon | Silicon | Silicon | Silicon | Silicon | Silicon |
| | | Hole type | Through-hole | Through-hole | Through-hole | Through-hole | Through-hole | Through-hole | Through-hole |
| | | Via diameter (µm) | 30 | 30 | 30 | 30 | 30 | 30 | 30 |
| | | Via depth (µm) | 300 | 300 | 300 | 300 | 300 | 300 | 300 |
| step a | | Filling method | Vacuum press | Vacuum press | Vacuum press | Vacuum press | Vacuum press | Vacuum press | Vacuum press |
| step b | | Temperature (°C) | 130 | 130 | 90 | 90 | 90 | 90 | 90 |
| | | Atmosphere | 100% N₂ | 100% N₂ | Ambient atmosphere | Ambient atmosphere | Ambient atmosphere | Ambient atmosphere | Ambient atmosphere |
| step c | | Removing method | Squeegee | Squeegee | Squeegee | Squeegee | Squeegee | Squeegee | Squeegee |
| step d | | Temperature (°C) | 220 | 220 | 220 | 220 | 220 | 220 | 220 |
| | | Atmosphere | 100% H₂ | 100% H₂ | 100% H₂ | 100% H₂ | 100% H₂ | 100% H₂ | 100% H₂ |
| Conductive via | Crack | | Absence | Absence | Absence | Absence | Absence | Absence | Absence |
| | Void | | Absence | Absence | Absence | Absence | Absence | Absence | Absence |
| | Recess after sintering | (µm) | 2 | 1.5 | 0.6 | 0.6 | 0.6 | 0.4 | 0.3 |
| | | Criteria | B | B | A | A | A | A | A |
| | Recess after resist peeling | (µm) | 2.8 | 2.9 | 0.8 | 0.8 | 0.8 | 0.6 | 0.4 |
| | | Criteria | B | B | A | A | A | A | A |
| Wiring board | Initial resistance value | | A | A | A | A | A | A | A |
| | After reliability test | 50 cycles | A | A | A | A | A | A | A |
| | | 100 cycles | A | A | A | A | A | A | A |
| | | 300 cycles | A | A | A | A | A | A | A |
| | | 500 cycles | A | A | A | A | A | A | A |
| | Cracking in substrate | | Absence | Absence | Absence | Absence | Absence | Absence | Absence |

**[Table 8]**

| | | | Comparative Example 1 | Comparative Example 2 |
|---|---|---|---|---|
| Metal paste | | | Preparation Example 25 | Preparation Example 26 |
| Substrate | | Material | Silicon | Silicon |
| | | Hole type | Through-hole | Through-hole |
| | | Via diameter (µm) | 30 | 30 |
| | | Via depth (µm) | 300 | 300 |
| step a | | Filling method | Vacuum press | Vacuum press |
| step b | | Temperature (°C) | 130 | 130 |
| | | Atmosphere | 100% N₂ | 100% N₂ |
| step c | | Removing method | Squeegee | Squeegee |
| step d | | Temperature (°C) | 220 | 220 |
| | | Atmosphere | 100% H₂ | 100% H₂ |
| Conductive via | Crack | | Presence | Presence |
| | Void | | Presence | Absence |
| | Recess after sintering | (µm) | 5.3 | 3.7 |
| | | Criteria | D | C |
| | Recess after resist peeling | (µm) | 9.5 | 6.3 |
| | | Criteria | E | D |
| Wiring board | Initial resistance value | | C | C |
| | After reliability test | 50 cycles | D | C |
| | | 100 cycles | E | D |
| | | 300 cycles | E | E |
| | | 500 cycles | E | E |
| | Cracking in substrate | | Absence | Absence |

### Reference Signs List

- 1: Silicon wafer

- 2: Metal coating
- 3: Metal paste part
- 3b: Conductive via precursor
- 3c: Conductive via
- 3p: Metal particle-containing layer
- 7: Support film
- 8a: Etching resist
- 9: Wiring
- 30: Through-hole
- 31: Blind-hole
- 40, 41: Silicon substrate
- 42: Rubber squeegee
- 50: Conductive via-containing substrate
- 52: Conductive via-containing wiring board
- 55: Test piece
- A: Pressure jig

## Claims

1. A method for manufacturing a conductive via-containing substrate, the method comprising:
step a of preparing a substrate provided with a hole and providing a metal paste part containing metal particles and a volatile solvent to cover at least a surface surrounding the hole of the substrate while an inside of the hole is filled with the metal paste part;
step b of heating the metal paste part to remove a part of the volatile solvent;
step c of removing a part of the metal paste part after heating to expose the surface to form a conductive via precursor in the hole, the conductive via precursor containing the metal particles and a residue of the volatile solvent and having a planarized exposed surface; and
step d of firing the conductive via precursor, wherein
the metal particles include first copper particles having an average particle diameter of 0.8 µm or more, second copper particles having an average particle diameter of 0.5 µm or less, and solder particles, and
the metal particles in the metal paste part provided in step a have a concentration of 94% by mass or more.

2. A metal paste comprising:
metal particles; and
a volatile solvent, wherein
the metal particles include first copper particles having an average particle diameter of 0.8 µm or more, second copper particles having an average particle diameter of 0.4 µm or less, and solder particles, and
the metal particles have a concentration of 94% by mass or more.

3. The metal paste according to Claim 2, wherein
the first copper particles contain a wet copper powder and an atomized copper powder.

4. The metal paste according to Claim 2 or 3, wherein
the volatile solvent contains a high vapor pressure solvent having a vapor pressure of 4 Pa or more and 30 Pa or less at 20°C.

5. The metal paste according to Claim 4, wherein
the volatile solvent further contains a low vapor pressure solvent having a vapor pressure of less than 4 Pa at 20°C.

6. A conductive via-containing substrate comprising:
a substrate having a through-hole; and
a conductive via part provided in the through-hole, wherein
the conductive via part contains a sintered body containing the metal paste according to Claim 2 or 3.

7. A conductive via-containing substrate comprising:
a substrate having a through-hole, and
a conductive via part provided in the through-hole, wherein
the conductive via part contains a metal body including a copper sintered body having a porous structure, a solder present in the copper sintered body in an interspersed manner, and pores, and
an average step height between a surface of the substrate and the conductive via part is 5 µm or less.
